(19) Europäisches Patentamt
European Patent Office
Office européen des brevets

(11) EP 1 467 250 B1

(12) **EUROPEAN PATENT SPECIFICATION**

(45) Date of publication and mention of the grant of the patent:
**22.10.2008 Bulletin 2008/43**

(51) Int Cl.:
***G03F 7/004*** $^{(2006.01)}$ ***B41C 1/10*** $^{(2006.01)}$
***C07F 5/02*** $^{(2006.01)}$

(21) Application number: **04008640.7**

(22) Date of filing: **08.04.2004**

(54) **Photosensitive composition and litographic printing plate precursor**

Lichtempfindliche Zusammensetzung und lithographischer Druckplattenvorläufer

Composition photosensible et plaque d'impression lithographique

(84) Designated Contracting States:
**AT BE BG CH CY CZ DE DK EE ES FI FR GB GR HU IE IT LI LU MC NL PL PT RO SE SI SK TR**

(30) Priority: **10.04.2003 JP 2003106677**

(43) Date of publication of application:
**13.10.2004 Bulletin 2004/42**

(73) Proprietor: **FUJIFILM Corporation**
**Minato-ku**
**Tokyo (JP)**

(72) Inventor: **Murota, Yasubumi**
**Yoshida-cho**
**Haibara-gun**
**Shizuoka (JP)**

(74) Representative: **HOFFMANN EITLE**
**Patent- und Rechtsanwälte**
**Arabellastrasse 4**
**81925 München (DE)**

(56) References cited:
**EP-A- 1 391 784**
**EP-A- 1 431 032**
**EP-A- 1 449 651**
**US-A- 5 496 903**

- **PATENT ABSTRACTS OF JAPAN vol. 2002, no. 08, 5 August 2002 (2002-08-05) & JP 2002 116539 A (FUJI PHOTO FILM CO LTD), 19 April 2002 (2002-04-19) & DATABASE WPI Section Ch, Week 200260 Derwent Publications Ltd., London, GB; Class A89, AN 2002-560605 & JP 2002 116539 A (FUJI PHOTO FILM CO LTD) 19 April 2002 (2002-04-19)**

EP 1 467 250 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

FIELD OF THE INVENTION

The present invention relates to a photosensitive composition and a lithographic printing plate precursor using the same. More particularly, the invention relates to a photosensitive composition useful as a photosensitive layer of a negative working lithographic printing plate precursor and a negative working lithographic printing plate precursor using the photosensitive composition.

BACKGROUND OF THE INVENTION

Hither, lithographic printing plate precursors having a constitution in which an oleophilic photosensitive resin layer is provided on a hydrophilic support have been widely used. With respect to the production method thereof, in general, a method of obtaining a desired printing plate by undergoing mask exposure (surface exposure) through a lith film and then dissolving and removing a non-image area was employed.

In recent years, digital techniques for electronic processing, storage and output of image information using a computer have become widespread, and a variety of new image output systems corresponding thereto have been put into practical use. As a result, a computer-to-plate (CTP) technique in which light having high directivity, such as lasers, is scanned according to digitalized image information, thereby directly producing a printing plate without the aid of a lith film is desired, and it is an important technical problem to obtain a lithographic printing plate precursor adaptive thereto.

As such a scanning exposable lithographic printing plate precursor, those having a constitution in which an oleophilic photosensitive resin layer containing a photosensitive compound capable of generating an active seed such as a radical and a Bronsted acid upon laser exposure (this oleophilic photosensitive resin layer will be often simply referred to as "photosensitive layer", hereinafter) is provided on a hydrophilic support are proposed and already marketed. A negative working lithographic printing plate can be obtained by subjecting this lithographic printing plate precursor to laser scanning exposure based on digital information to generate an active seed, causing a physical or chemical change in the photosensitive layer by the action of the active seed to insolubilize the photosensitive layer, and subsequently developing it.

As negative working lithographic printing plate precursors, those in which a photopolymerization type photosensitive layer containing a photopolymerization initiator having excellent photosensitive speed, an addition polymerizable ethylenically unsaturated compound and a binder polymer soluble in an alkaline developing solution and optionally, an oxygen shielding protective layer are provided on a hydrophilic support are known. Such lithographic printing plate precursors have a desired printing performance in view of advantages of excellent productivity, simple development processing, and good resolution and ink acceptability.

For example, in WO 00/48836, a composition containing a polycarboxylic acid and a printing plate precursor applying the same are disclosed, and an active halogen compound is used as a polymerization initiator. However, at the time of manufacture of a printing plate precursor, especially when Al is used as a substrate, the active halogen compound is liable to be catalytically reduced with the metal, the catalytically reduced active halogen compound is decomposed to generate an active radical and start polymerization. Accordingly, there was encountered such a problem that residual colors in a non-image area are likely caused.

On the other hand, in JP-A-2002-90989 and JP-A-2002-23361, examples of lithographic printing plates using a borate compound are disclosed. Though these lithographic printing plates have very high sensitivity, their storage stability is not sufficient, and therefore, further improvements were desired.

EP-A-1 449 651, which is prior art under Art. 54(3) EPC, relates to a polymerizable composition containing (A) a compound, which causes decarboxylation and/or dehydration by heat, which includes compounds carrying a carboxylic acid group, (B) a radical initiator, including borate compounds as one alternative, C) a compound having an ethylenically unsaturated bond and (D) an IR absorber. Furthermore, the composition may contain (E) a binder polymer.

EP-A-1 431 032 relates to polymerizable compositions containing a binder polymer (A), a compound (B) having a polymerizable unsaturated group and a compound having a triarylsulfonium salt structure (C), which may be, among others, a carboxylic acid group containing compound. As further optional constituents a compound having an absorption maximum at 700-1200 nm (D), an a compound (ii) which forms active radicals after oxidation, such as triarylalkyl borates, are mentioned.

EP-A-1 391 784 discloses a polymerizable composition comprising, as mandatory constituents, a binder polymer and a radical-generating compound, such as borate compounds. In addition to these mandatory components, individually selectable optional additives mentioned include, among others, ethylenically unsaturated radical polymerizable compounds and IR-light-absorbing compounds.

US 5,496,903 refers to a near IR polymerizable composition comprising as a mandatory constituent a cyanine dye having an absorption maximum in the range of 600-1100 nm, an S-triazine compound, an organoboron salt and an

ethylenically unsaturated compound. The ethylenically unsaturated compound includes certain unsaturated carboxylic acids as one alternative. Also, polymer binders may additionally present.

JP-A-2002-116539 discloses a photosensitive layer containing (A) an onium salt-type polymerization initiator, (B) a photothermal converting agent, (C) a compound having a polymerizable unsaturated group, and (D) a borate compound.

SUMMARY OF THE INVENTION

The invention is aimed to solve the foregoing problems of the related art and achieve the following objects.

That is, a first object of the invention is to provide a photosensitive composition having high sensitivity and good storage stability (unprocessed stock storability) and useful as a photosensitive layer of a negative working lithographic printing plate precursor.

A second object of the invention is to provide a negative working lithographic printing plate precursor capable of being recorded with high sensitivity by infrared laser and having excellent storage stability (unprocessed stock storability) and printing resistance.

Means for solving the foregoing problems are as follows.

Specifically, the present invention provides a photosensitive composition containing

(i) an infrared absorber,

(ii) a borate compound,

(iii) a polymerizable compound containing at least one ethylenically unsaturated double bond,

(iv)a binder polymer, and

(v) a compound having a weight average molecular weight of not more than 3,000 and containing at least one carboxylic acid group,

with the proviso that the following two compositions, wherein the borate compound (ii) is a compound of the following formula:

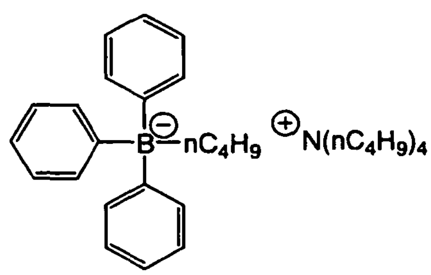

and the compound (v) is selected from the following two formulae:

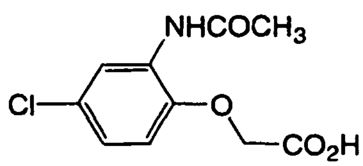

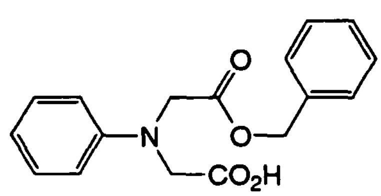

are excluded.

Also, the present invention provides a lithographic printing plate precursor comprising, in this order, a support, a photosensitive layer containing the above photosensitive composition, and a protective layer.

The above compound having a weight average molecular weight of not more than 3,000 and containing at least one carboxylic acid group hereinafter also will be simply referred to as "carboxylic acid compound".

It is preferable that the carboxylic acid group-containing compound contains two or more carboxylic acid groupss or at least one acid group other than a carboxylic acid group.

Also, in the lithographic printing plate precursor of the invention the teaching that a photosensitive layer and a protective layer are provided in this order on a support does not deny the presence of other layers (for example, an interlayer and backcoat layer) which are provided according to the object.

Though the action of the invention is not always clear, it is estimated as follows.

That is, it is estimated that the carboxylic acid compound used in the invention is excellent in alkaline solubility and is free from any change of the alkaline solubility with time, thereby improving the unprocessed stock storability. It is thought that by using this carboxylic acid compound together with a borate compound, it becomes possible to cope with sensitivity and storage stability. Also, it is thought that a lithographic printing plate precursor using such a photosensitive composition in a photosensitive layer can exhibit excellent effects in all of high-sensitivity recording, suppression of residual film generation in a non-image area and printing resistance in an image area even after storage with time of an unexposed photosensitive material.

BRIEF DESCRIPTION OF THE DRAWINGS

[Fig. 1]

A schematic constitutional view showing one example of a DRM interference wave analyzer for measuring the dissolution behavior of the photosensitive layer.

[Fig. 2]

A schematic constitutional view showing one example of a method of measuring the electrostatic capacity used for evaluating diffusibility of a developing solution into the photosensitive layer.

[Fig. 3]

A side view showing a concept of a brush graining step used for mechanical roughing processing in the preparation of a support for lithographic printing plate according to the invention.

[Fig. 4]

A graph showing one example of an alternating current power source waveform used for electrochemical roughing processing in the preparation of a support for lithographic printing plate according to the invention.

[Fig. 5]

A side view showing one example of a radial type cell in electrochemical roughing processing using an alternating current in the preparation of a support for lithographic printing plate according to the invention.

[Fig. 6]

A schematic view of an anodic oxidation processing device used for anodic oxidation processing in the preparation of a support for lithographic printing plate according to the invention.

[Description of the Reference Numerals and Signs]

1: Aluminum plate
2, 4: Roller-state brush
3: Polishing slurry liquid
5, 6, 7, 8: Supporting roller
11: Aluminum plate
12: Radial drum roller
13a, 13b: Main electrode
14: Electrolytic processing liquid

15: Supply port of electrolytic liquid
16: Slit
17: Passage of electrolytic liquid
18: Auxiliary anode
19a, 19b: Thyristor
20: Alternating current power source
21: Main electrolytic cell
22: Auxiliary anode cell
410: Anodic oxidation processing device
412: Current supply cell
414: Electrolytic processing cell
416: Aluminum plate
418, 426: Electrolytic liquid
420: Current supply electrode
422, 428: Roller
424: Nip roller
430: Electrolytic electrode
432: Cell wall
434: Direct current power source

DETAILED DESCRIPTION OF THE INVENTION

The invention will be described below in detail.

[Photosensitive composition]

The photosensitive composition of the invention is characterized by containing an infrared absorber, a borate compound, a polymerizable compound containing at least one ethylenically unsaturated double bond, a binder polymer, and a compound having a weight average molecular weight of not more than 3,000 and containing at least one carboxylic acid group (carboxylic acid compound).

Each of the components to be contained in the photosensitive composition will be successively described below.

(Carboxylic acid compound)

The carboxylic acid compound according to the invention is a compound having a weight average molecular weight of not more than 3,000 and containing at least one carboxylic acid group. Such a compound can be selected from compounds such as optionally substituted aliphatic carboxylic acids, optionally substituted aromatic carboxylic acids, and carboxylic acids directly connected to an optionally substituted heterocyclic ring. Of these, phthalic acid derivatives, trimellitic acid derivatives, pyromellitic acid derivatives, succinic acid derivatives, benzoic acid derivatives, and glycine derivatives are suitable.

The carboxylic acid compound according to the invention preferably contains two or more carboxylic acid groups or at least one acid group other than a carboxylic acid group. Examples of the acid group other than a carboxylic acid group include sulfonic acid, phosphonic acid, phosphinic acid, and phenol.

The weight average molecular weight of the carboxylic acid compound must be not more than 3,000 and is preferably from 60 to 2,000, and more preferably from 100 to 1,500. When the weight average molecular weight exceeds 3,000, the carboxylic acid compound may possibly adsorb on the support.

Specific examples of the carboxylic acid compound that is suitably used in the invention will be given below (Compound Nos. 1 to 21), but it should not be construed that the invention is limited thereto.

1 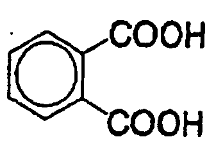

2 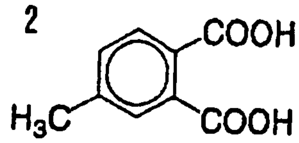

3 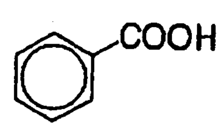

4 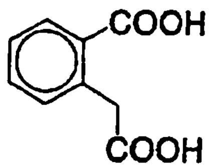

5 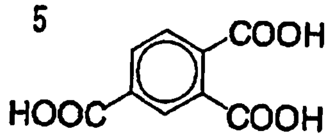

6 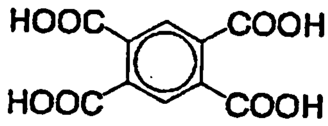

7 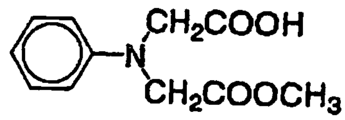

8 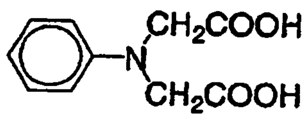

9 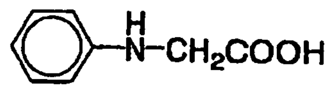

10 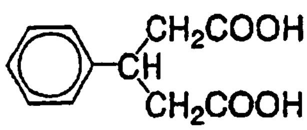

11 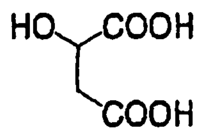

12 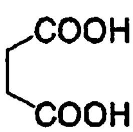

13 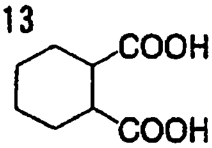

14 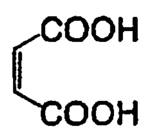

15 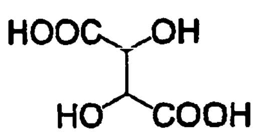

16 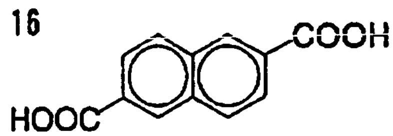

17 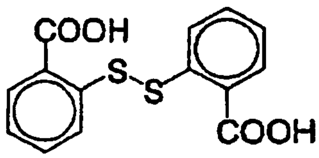

18 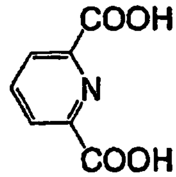

19 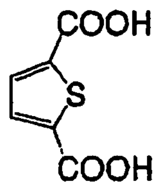

20 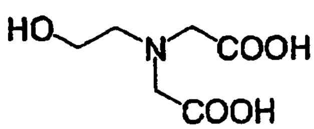

21 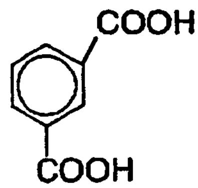

In the photosensitive composition of the invention, the content of the carboxylic acid compound is preferably from 0.5 % by weight to 30 % by weight, and more preferably from 2 % by weight to 20 % by weight in the whole of solids. Also, the carboxylic acid compound may be used singly or in admixture of two or more thereof.

(Borate compound (polymerization initiator))

The photosensitive composition of the invention contains, as the essential compound, a borate compound as a polymerization initiator.

In the invention, as the borate compound, conventionally known compounds can be used without limitations. Examples thereof include those described in JP-A-62-143044, JP-A-62-150242, JP-A-5-5988, and JP-A-5-197069.

Also, compounds represented by the following formula (I) can be used.

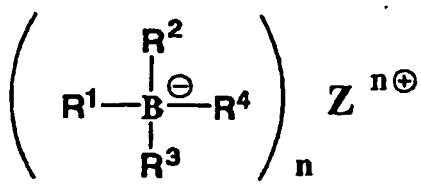

(I)

In the formula, $R^1$, $R^2$, $R^3$, and $R^4$ each independently represents an organic group, provided that at least one of $R^1$, $R^2$, $R^3$, and $R^4$ represents an alkyl group. $Z^{n+}$ represents a cation having a valence of n; and n represents an integer of from 1 to 6.

In the formula (I), examples of $R^1$, $R^2$, $R^3$, and $R^4$ include an alkyl group, a substituted alkyl group, an aryl group, a substituted aryl group, an alkenyl group, a substituted alkenyl group, an alkynyl group, a substituted alkynyl group, and a heterocyclic group, provided that at least one of $R^1$, $R^2$, $R^3$, and $R^4$ represents a substituted or unsubstituted alkyl group.

Preferred specific examples of the compound represented by the formula (I) will be given below, but it should not be construed that the invention is limited thereto.

| | $R^1$ | $R^2$ | $R^3$ | $R^4$ | $Z^+$ |
|---|---|---|---|---|---|
| I-1 | Mesityl | Mesityl | Phenyl | Methyl | $N(CH_3)_4$ |

(continued)

| | $R^1$ | $R^2$ | $R^3$ | $R^4$ | $Z^+$ |
|---|---|---|---|---|---|
| I-2 | Mesityl | Mesityl | Phenyl | Butyl | $N(CH_3)_4$ |
| I-3 | Bromomesityl | Bromomesityl | Phenyl | Methyl | $N(CH_3)_4$ |
| I-4 | Dichloromesityl | Dichloromesityl | Phenyl | Methyl | $N(CH_3)_4$ |
| I-5 | Dichloromesityl | Dichloromesityl | Phenyl | Butyl | $N(CH_3)_4$ |
| I-6 | Chloromesityl | Chloromesityl | Phenyl | Methyl | $N(CH_3)_4$ |
| I-7 | Chloromesityl | Chloromesityl | Phenyl | Butyl | $N(CH_3)_4$ |
| I-8 | Mesityl | Mesityl | p-Fluorophenyl | Methyl | $N(CH_3)_4$ |
| I-9 | Mesityl | Mesityl | p-Fluorophenyl | Butyl | $N(CH_3)_4$ |
| I-10 | Mesityl | Mesityl | m-Fluorophenyl | Methyl | $N(CH_3)_4$ |
| I-11 | Mesityl | Mesityl | m-Fluorophenyl | Butyl | $N(CH_3)_4$ |
| I-12 | Mesityl | Mesityl | 3,4-Difluorophenyl | Methyl | $N(CH_3)_4$ |
| I-13 | Mesityl | Mesityl | 3,4-Difluorophenyl | Methyl | $N(CH_3)_4$ |
| I-14 | Mesityl | Mesityl | 3,5-Bis (trifluoromethyl) phenyl | Methyl | $N(CH_3)_4$ |
| I-15 | Mesityl | Mesityl | 3,5-Bis (trifluoromethyl) phenyl | Butyl | $N(CH_3)_4$ |
| I-16 | Mesityl | Mesityl | 3-Bromo-5-fluorophenyl | Methyl | $N(CH_3)_4$ |
| I-17 | Mesityl | Mesityl | p-Chlorophenyl | Methyl | $N(CH_3)_4$ |
| I-18 | Mesityl | Mesityl | p-Chlorophenyl | Butyl | $N(CH_3)_4$ |
| I-19 | Mesityl | Mesityl | m-Chlorophenyl | Methyl | $N(CH_3)_4$ |
| I-20 | Mesityl | Mesityl | m-Chlorophenyl | Butyl | $N(CH_3)_4$ |
| I-21 | Mesityl | Mesityl | p-Bromophenyl | Methyl | $N(CH_3)_4$ |
| I-22 | Chloromesityl | Chloromesityl | p-Bromophenyl | Methyl | $N(CH_3)_4$ |
| I-23 | Mesityl | Mesityl | 2,5-Dimethyl-4-bromophenyl | Methyl | $N(CH_3)_4$ |
| I-24 | Mesityl | Mesityl | Mesityl | Methyl | $N(CH_3)_4$ |
| I-25 | p-Chlorophenyl | p-Chlorophenyl | Phenyl | Butyl | $N(CH_3)_4$ |
| I-26 | p-Chlorophenyl | p-Chlorophenyl | Butyl | Methyl | $N(CH_3)_4$ |
| I-27 | o-Tolyl | o-Tolyl | o-Tolyl | Methyl | $N(CH_3)_4$ |
| I-28 | o-Tolyl | o-Tolyl | o-Tolyl | Butyl | $N(CH_3)_4$ |
| I-29 | o-Methoxyphenyl | o-Methoxyphenyl | o-Methoxyphonyl | Butyl | $N(CH_3)_4$ |
| I-30 | Mesityl | Mesityl | Butyl | Methyl | $N(CH_3)_4$ |
| I-31 | Mesityl | Mesityl | $(CH_3)_3$-Si-$CH_2$- | Methyl | $N(CH_3)_4$ |
| I-32 | Mesityl | Mesityl | Phenyl | Phenyl | $N(C_{10}H_{21})_4$ |
| I-33 | Mesityl | Mesityl | Phenyl | Phenyl | Cyanine |

(continued)

| | $R^1$ | $R^2$ | $R^3$ | $R^4$ | $Z^+$ |
|---|---|---|---|---|---|
| I-34 | $(CH_3)_3$-Si-$CH_2$- | $(CH_3)_3$-Si-$CH_2$- | $(CH_3)_3$-Si-$CH_2$- | $(CH_3)_3$-Si-$CH_2$- | $N(CH_3)_4$ |
| I-35 | $(CH_3)_3$-Si-$CH_2$- | $(CH_3)_3$-Si-$CH_2$- | $(CH_3)_3$-Si-$CH_2$- | $(CH_3)_3$-Si-$CH_2$- | $N(C_4H_9)_4$ |
| I-36 | $(CH_3)_3$-Si-$CH_2$- | $(CH_3)_3$-Si-$CH_2$- | $(CH_3)_3$-Si-$CH_2$- | $(CH_3)_3$-Si-$CH_2$- | Benzyltrimethylammonium |
| I-37 | $(CH_3)_3$-Si-$CH_2$- | $(CH_3)_3$-Si-$CH_2$- | $(CH_3)_3$-Si-$CH_2$- | $(CH_3)_3$-Si-$CH_2$- | Benzyltriethylammonium |
| I-38 | $(CH_3)_3$-Si-$CH_2$- | $(CH_3)_3$-Si-$CH_2$- | $(CH_3)_3$-Si-$CH_2$- | Methyl | $N(CH_3)_4$ |
| I-39 | Chloromesityl | Chloromesityl | Chloromesityl | Methyl | $N(CH_3)_4$ |
| I-40 | Chloromesityl | Chloromesityl | Chloromesityl | Butyl | $N(CH_3)_4$ |
| I-41 | Dichloromesityl | Dichloromesityl | Dichloromesityl | Methyl | $N(CH_3)_4$ |
| I-42 | m-Tolyl | m-Tolyl | m-Tolyl | Methyl | $N(CH_3)_4$ |
| I-43 | p-Tolyl | p-Tolyl | p-Tolyl | Methyl | $N(CH_3)_4$ |
| I-44 | Mesityl | Mesityl | o-Tolyl | Methyl | $N(CH_3)_4$ |
| I-45 | Mesityl | Mosityl | p-Dimethylaminophenyl | Methyl | $N(CH_3)_4$ |
| I-46 | Mesityl | Mesityl | Mesityl | Methyl | $N(CH_3)_4$ |
| I-47 | Dichloromethyl | Dichloromethyl | 4'-Bromobiphenyl | Methyl | $N(CH_3)_4$ |
| I-48 | Mesityl | Mesityl | 9-Phenanthryl | Butyl | $N(CH_3)_4$ |
| I-49 | Mesityl | Mesityl | 1-Naphthyl | Methyl | $N(CH_3)_4$ |
| I-50 | Mesityl | Mesityl | 1-Naphthyl | Butyl | $N(CH_3)_4$ |
| *: Compound I-38 is a mixture of Compound I-34, tetramethylammoniummethyl tris(trimethylsilylmethyl)borate and tetramethylammoniumdimethyl bis(trimethylsilylmethyl)borate (3/10/1). | | | | | |

| | $R^2$ | $R^1$, $R^2$ and $R^4$ (the same) | $Z^+$ |
|---|---|---|---|
| I-51 | Butyl | 2,5-Difluorophenyl | $N(CH_3)_4$ |
| I-52 | Hexyl | 4-Chlorophenyl | $N(CH_3)_4$ |
| I-53 | Hexyl | 3-Trifluoromethylphenyl | $NH_4$ |
| I-54 | Butyl | 3-Fluorophenyl | $N(CH_3)_4$ |
| I-55 | Hexyl | 3-Fluorophenyl | $N(CH_3)_4$ |
| I-56 | Ethyl | 3-Fluorophenyl | $N(CH_3)_4$ |
| I-57 | Ethyl | 3-Fluorophenyl | $N(C_4H_9)_4$ |
| I-58 | Hexyl | 3-Fluorophenyl | QTX *1 |
| I-59 | Hexyl | 3-Fluorophenyl | Cyanine *2 |
| I-60 | Hexyl | 3,5-Difluorophenyl | $N(CH_3)_4$ |
| I-61 | Methyl | 2-(Trifluoromethyl)phenyl | $N(CH_3)_4$ |
| I-62 | Butyl | 2-(Trifluoromethyl)phenyl | $N(CH_3)_4$ |

(continued)

| | $R^2$ | $R^1$, $R^2$ and $R^4$ (the same) | $Z^+$ |
|---|---|---|---|
| I-63 | Butyl | 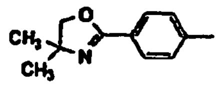 | $N(CH_3)_4$ |
| I-64 | Methyl | 4-Bromophenyl | $N(CH_3)_4$ |
| I-65 | Hexyl | 3-Chlorophenyl | $N(CH_3)_4$ |
| I-66 | Hexyl | 4-Bromophenyl | $N(CH_3)_4$ |
| I-67 | Butyl | 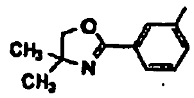 | $N(CH_3)_4$ |
| I-68 | Benzyl | m-Fluorophenyl | $N(CH_3)_4$ |
| I-69 | Hexyl | m-Fluorophenyl | $N(C_4H_9)_4$ |
| I-70 | Hexyl | m-Fluorophenyl | $N(C_{10}H_{21})_4$ |
| I-71 | Hexyl | m-Fluorophenyl | Iodonium *3 |
| I-72 | Hexyl | m-Fluorophenyl | Pyrylium *4 |
| I-73 | Hexyl | m-Fluorophenyl | Methyl Blue cation |
| I-74 | Hexyl | m-Fluorophenyl | Safranine-o-cation |
| I-75 | Hexyl | m-Phenoxyphenyl | $N(CH_3)_4$ |
| I-76 | Hexyl | p-(Diisopropylaminosulfonyl)phen yl | $N(CH_3)_4$ |
| I-77 | Hexyl | p-(2,6-Di-tert-butyl-4-methylpheno xycarbonyl)phenyl | $N(CH_3)_4$ |
| I-78 | Hexyl | p-(Diisopropylaminocartionyl)phe nyl | $N(CH_3)_4$ |
| I-79 | Methyl | Dichloromesityl | $N(CH_3)_4$ |

| | $R^1$ | $R^2$ | $R^3$ | $R^4$ | $Z^+$ |
|---|---|---|---|---|---|
| I-80 | Butyl | p-Bromophenyl | Mesityl | Mesityl | $N(CH_3)_4$ |
| I-81 | Butyl | p-Fluorophenyl | Mesityl | Mesityl | $N(CH_3)_4$ |
| I-82 | p-Methylbenzyl | p-Chlorophenyl | Mesityl | Mesityl | $N(CH_3)_4$ |
| I-83 | Hexyl | Phenyl | o-Methylphenyl | p-Chlorophenyl | $N(CH_3)_4$ |
| I-84 | Allyl | m-Fluorophenyl | m-Fluorophenyl | m-Fluorophenyl | $N(CH_3)_4$ |
| I-85 | p-Methylbenzyl | m-Fluorophenyl | m-Fluorophenyl | m-Fluorophenyl | $N(CH_3)_4$ |
| I-86 | α-Methylbenzyl | m-Fluorophenyl | m-Fluorophenyl | m-Fluorophenyl | $N(CH_3)_4$ |

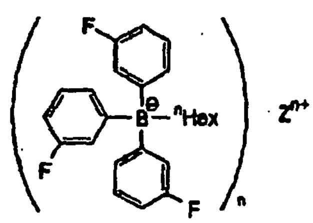

| | n | Z |
|---|---|---|
| I-87 | 1 | Na |
| I-88 | 1 | 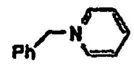 |
| I-89 | 1 | 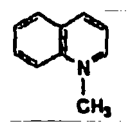 |
| I-90 | 1 | 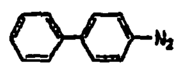 |
| I-91 | 1 | 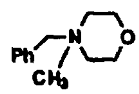 |
| I-92 | 1 | 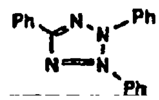 |
| I-93 | 1 | 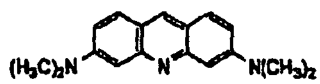 |
| I-94 | 1 | $P(n-C_4H_9)_4$ |
| I-95 | 1 | $SPh_3$ |
| I-96 | 1 | Ph-I-Ph |
| I-97 | 2 | Cu |
| I-98 | 1 | Ag |
| I-99 | 2 | Hg |
| I-100 | 2 | Pd |
| I-101 | 2 | Ni |

Of the borate compounds represented by the foregoing formula (I), compounds containing at least one phenyl group substituted with fluorine at the m-position thereof are more preferable.

The borate compound may be used singly or in admixture of two or more thereof. With respect to the content, the borate compound can be added in a proportion of from 0.1 to 30 % by weight, preferably from 0.5 to 25 % by weight, and especially preferably from 1 to 20 % by weight in the whole of solids of the photopolymerizable photosensitive layer.

In the invention, polymerization initiators other than the borate compound may be used jointly, if desired. Examples of polymerization initiators other than the borate compound include onium salts, halomethyl group-containing compounds, peroxides, azo based polymerization initiators, azide compounds, and quinonediazides. Of these, onium salts, especially sulfonium salts are preferable in view of storage stability.

In the invention, the onium salts that can be used jointly with the borate compound are specifically represented by the following formulae (II) to (IV).

Formula (II) $Ar^{11}-I^{+}-Ar^{12}\ Z^{11-}$

Formula (III) $Ar^{21}-N^{+}\equiv N\ Z^{21-}$

Formula (IV)

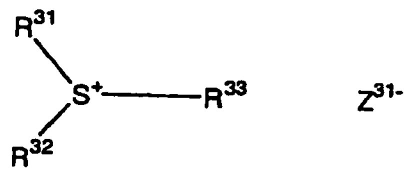

In the formula (II), $Ar^{11}$ and $Ar^{12}$ each independently represents an optionally substituted aryl group having not more than 20 carbon atoms. In the case where the aryl group contains a substituent, preferred examples of the substituent include a halogen atom, a nitro group, an alkyl group having not more than 12 carbon atoms, an alkoxy group having not more than 12 carbon atoms, and an aryloxy group having not more than 12 carbon atoms. $Z^{11-}$ represents a counter ion selected from the group consisting of a halogen ion, a perchloric acid ion, a tetrafluoroborate ion, a hexafluorophosphate ion, a carboxylate ion, and a sulfonic acid ion. Of these, a perchloric acid ion, a hexafluorophosphate ion, a carboxylate ion, and an arylsulfonic acid ion are preferable.
In the formula (III), $Ar^{21}$ represents an optionally substituted aryl group having not more than 20 carbon atoms. Preferred examples of substituents include a halogen atom, a nitro group, an alkyl group having not more than 12 carbon atoms, an alkoxy group having not more than 12 carbon atoms, an aryloxy group having not more than 12 carbon atoms, an alkylamino group having not more than 12 carbon atoms, a dialkylamino group having not more than 12 carbon atoms, an arylamino group having not more than 12 carbon atoms, and a diarylamino group having not more than 12 carbon atoms. $Z^{21-}$ represents a counter ion synonymous with $Z^{11-}$.
In the formula (IV), $R^{31}$, $R^{32}$, and $R^{33}$ may be the same or different and each represents an optionally substituted hydrocarbon group having not more than 20 carbon atoms. Preferred examples of substituents include a halogen atom, a nitro group, an alkyl group having not more than 12 carbon atoms, an alkoxy group having not more than 12 carbon atoms, and an aryloxy group having not more than 12 carbon atoms. $Z^{31-}$ represents a counter ion synonymous with $Z^{11-}$.
Specific examples of the onium salt include those described in paragraphs [0030] to [0033] of JP-A-2001-133969.
In the invention, as the polymerization initiator that can be used jointly with the borate compound, in addition to those described above, specific aromatic sulfonium salts described in JP-A-2002-148790, JP-A-2002-148790, JP-A-2002-350207, and JP-A-2002-6482 can be used.
The polymerization initiator to be used in the invention preferably has a maximum absorption wavelength of not more than 400 nm, and more preferably not more than 360 nm. By adjusting the absorption wavelength within the ultraviolet region in this way, handling of the lithographic printing plate precursor can be carried out under a white lamp.
The polymerization initiator can be added in a coating solution for photosensitive layer in a proportion of from 0.1 to 50 % by weight, preferably from 0.5 to 30 % by weight, and especially preferably from 1 to 20 % by weight based on the whole of solids of the coating solution for photosensitive layer. When the addition amount is less than 0.1 % by weight, the sensitivity tends to lower, whereas when it exceeds 50 % by weight, smuts may possibly be generated in a non-image area at the time of printing. The polymerization initiator may be added in the same layer as in other components or may be added in a layer separately provided.

(Infrared absorber)

It is essential to use an infrared absorber in the photosensitive composition of the invention. The infrared absorber has a function to convert the absorbed infrared light into heat. In this regard, the foregoing polymerization initiator (radical generator) causes heat decomposition due to the generated heat, thereby generating a radical. As the infrared absorber that is used in the invention, dyes or pigments having the absorption maximum in a wavelength of from 760 nm to 1,200 nm are preferable.
As the dyes, commercially available dyes and known dyes described in, for example, Dye Handbook (compiled by The Society of Synthetic Organic Chemistry, Japan and published in 1970) can be employed. Specific examples thereof include dyes such as azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarilium dyes, pyrylium salts, and metal thiolate complexes.
Preferred examples of the dyes include cyanine dyes described in JP-A-58-125246, JP-A-59-84356, JP-A-59-202829, and JP-A-60-78787; methine dyes described in JP-A-58-173696, JP-A-58-181690, and JP-A-58-194595;

naphthoquinone dyes described in JP-A-58-112793, JP-A-58-224793, JP-A-59-48187, JP-A-59-73996, JP-A-60-52940, and JP-A-60-73744; squarilium dyes described in JP-A-58-112792; and cyanine dyes described in British Patent No. 434,875.

Also, near infrared absorbing sensitizers described in U.S. Patent No. 5,156,938 are suitably used. Also, substituted arylbenzo(thio)pyrylium salts described in U.S. Patent No. 3,881,924; trimethinethiapyrylium salts described in JP-A-57-142645 (U.S. Patent No. 4,327,169) ; pyrylium based compounds described in JP-A-58-181051, JP-A-58-220143, JP-A-59-41363, JP-A-59-84248, JP-A-59-84249, JP-A-59-146063, and JP-A-59-146061; cyanine dyes described in JP-A-59-216146; pentamethinethiopyrylium salts described in U.S. Patent No. 4,283,475; and pyrylium compounds disclosed in JP-B-5-13514 and JP-B-5-19702 are preferably used. Also, other preferred examples of the dyes include near infrared absorbing dyes represented by the formulae (I) and (II) in U.S. Patent No. 4,756,993.

Also, other preferred examples of the infrared absorbing dye of the invention include specific indolenine cyanine dyes enumerated below, which are described in Japanese Patent Application No. 2001-6326 and JP-A-2002-278057.

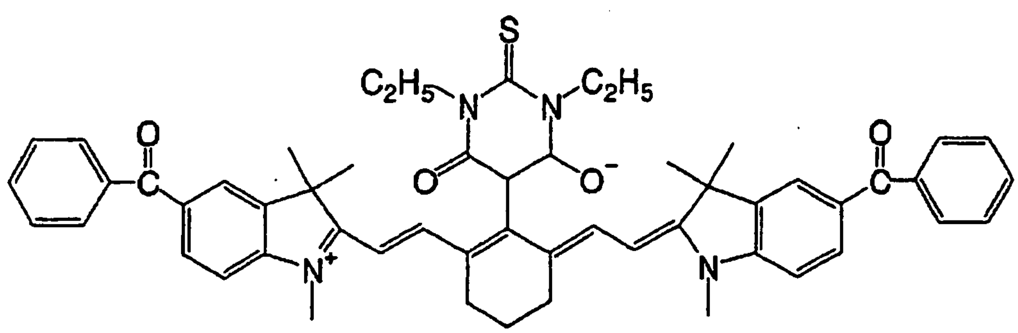

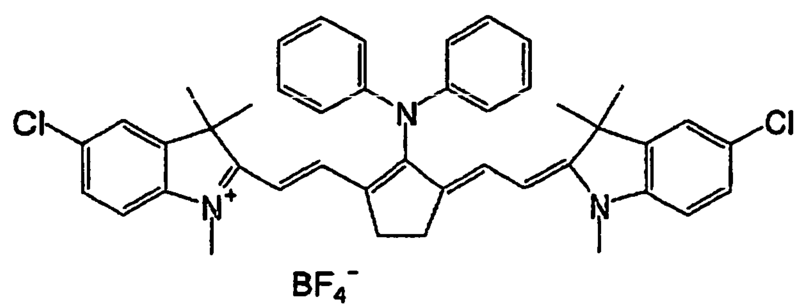

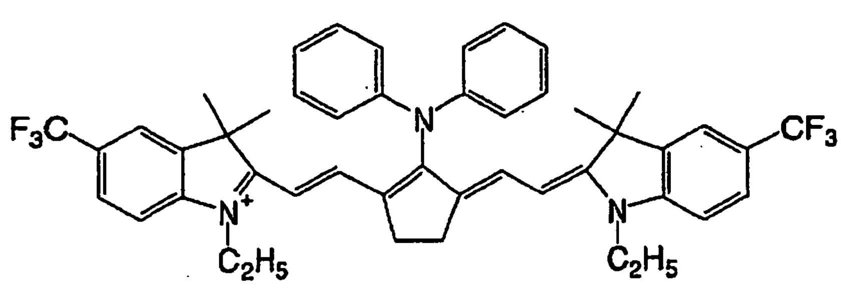

Of these dyes, cyanine dyes, squarilium dyes, pyrylium dyes, nickel thiolate complexes, and indolenine cyanine dyes are especially preferable. Further, cyanine dyes and indolenine cyanine dyes are preferable, and especially preferred examples of the dyes include cyanine dyes represented by the following formula (a).

Formula (a)

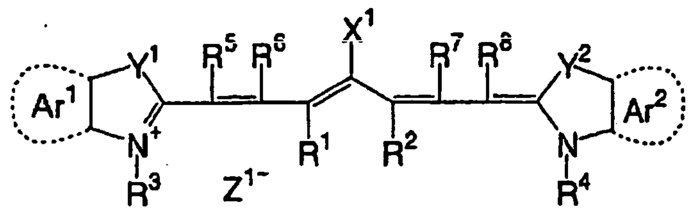

In the formula (a), $X^1$ represents a hydrogen atom, a halogen atom, $-NPh_2$, $X^2-L^1$, or the following group. Here, $X^2$ represents an oxygen atom, a nitrogen atom, or a sulfur atom; and $L^1$ represents a hydrocarbon group having from 1 to 12 carbon atoms, a hetero atom-containing aromatic ring, or a hetero atom-containing hydrocarbon group having from 1 to 12 carbon atoms. Incidentally, the hetero atom as referred to herein represents N, S, O a halogen atom, or Se. Ph represents a phenyl group.

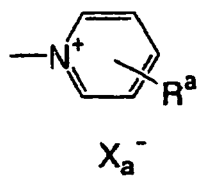

In the foregoing formula, $X_a^-$ is defined in the same manner as in $Z^{1-}$ described later; and $R^a$ represents a substituent selected from a hydrogen atom, an alkyl group, an aryl group, a substituted or unsubstituted amino group, and a halogen atom.

$R^1$ and $R^2$ each independently represents a hydrocarbon group having from 1 to 12 carbon atoms. Preferably, $R^1$ and $R^2$ each represents a hydrocarbon group having 2 or more carbon atoms in view of storage stability of a coating solution for recording layer; and especially preferably, $R^1$ and $R^2$ are bonded to each other to form a 5-membered or 6-membered ring.

$Ar^1$ and $Ar^2$ may be the same or different and each represents an optionally substituted aromatic hydrocarbon group. Preferred examples of the aromatic hydrocarbon group include a benzene ring and a naphthalene ring. Also, preferred examples of the substituent include a hydrocarbon group having not more than 12 carbon atoms, a halogen atom, and an alkoxy group having not more than 12 carbon atoms. $Y^1$ and $Y^2$ may be the same or different and each represents a sulfur atom or a dialkylmethylene group having not more than 12 carbon atoms. $R^3$ and $R^4$ may be the same or different and each represents an optionally substituted hydrocarbon group having not more than 20 carbon atoms. Preferred examples of the substituent include an alkoxy group having not more than 12 carbon atoms, a carboxyl group, and a sulfo group. $R^5$, $R^6$, $R^7$, and $R^8$ may be the same or different and each represents a hydrogen atom or a hydrocarbon group having not more than 12 carbon atoms. Of these, a hydrogen atom is preferable in view of easiness of availability of raw materials. Also, $Z^{1-}$ represents a counter anion. However, in the case where the cyanine dye represented by the formula (a) contains an anionic substituent within the structure thereof, and neutralization of a charge is not required, $Z^{1-}$ is not necessary. Preferred examples of $Z^{1-}$ include a halogen ion, a perchloric acid ion, a tetrafluoroborate ion, a hexafluorophosphate ion, and a sulfonic acid ion in view of storage stability of a coating solution for recording layer. Of these, a perchloric acid ion, a hexafluorophosphate ion, and an arylsulfonic acid ion are especially preferable.

In the invention, specific examples of the cyanine dye represented by the formula (a) that can be suitably used include those described in paragraphs [0017] to [0019] of JP-A-2001-133969.

Also, other especially preferred examples include specific indolenine cyanine dyes described in the foregoing Japanese Patent Application No. 2001-6326 and JP-A-2002-278057.

Also, in the case where a pigment is used as the infrared absorber, commercially available pigments and pigments described in *Color Index (C.I.) Handbook;* Saishin Ganryo Binran (Current Pigment Handbook), compiled by Nippon Ganryo Pigment Kyokai (1977); Saishin Ganryo Ohyo Gijutsu (Current Pigment Application Technologies), published by CMC Publishing Co., Ltd. (1986); and Insatsu Inki Gijutsu (Printing Ink Technologies), published by CMC Publishing Co., Ltd. (1984) can be applied.

Examples of the pigment include black pigments, yellow pigments, orange pigments, brown pigments, red pigments, violet pigments, blue pigments, green pigments, fluorescent pigments, metal powder pigments, and other polymer-binding dyes. Specific examples include insoluble azo pigments, azo lake pigments, condensed azo pigment, chelate azo pigments, phthalocyanine based pigments, anthraquinone based pigments, perylene based pigments, perinone based pigments, thioindigo based pigments, quinacridone based pigments, dioxazine based pigments, isoindolinone based pigments, quinophthalone based pigments, dyeing lake pigments, azine pigments, nitroso pigments, nitro pigments, natural pigments, fluorescent pigments, inorganic pigments, and carbon black. Of these pigments, carbon black is preferable.

The pigment may be used without surface processing or upon surface processing. As the surface processing method, there can be considered a method of coating the surface with a resin or a wax, a method of adhering a surfactant, and a method of binding a reactive substance (such as silane coupling agents, epoxy compounds, and polyisocyanates) to the pigment surface. These methods are described in Kinzoku Sekken No Seishitsu To Ohyo (Properties and Applications of Metallic Soaps), published by Saiwai Shobo; Insatsu Inki Gijutsu (Printing Ink Technologies), published by CMC Publishing Co., Ltd. (1984) ; and Saishin Ganryo Ohyo Gijutsu (Current Pigment Application Technologies), published by CMC Publishing Co., Ltd. (1986).

The particle size of the pigment is preferably in the range of from 0.01 $\mu$m to 10 $\mu$m, more preferably from 0.05 $\mu$m to 1 $\mu$m, and especially preferably from 0.1 $\mu$m to 1 $\mu$m.

As a method of dispersing the pigment, known dispersion techniques to be used in the ink production or toner production can be employed. Examples of dispersing machines include a ultrasonic dispersion machine, a sand mill, an attritor, a pearl mill, a super mill, a ball mill, an impeller, a disperser, a KD mill, a colloid mill, a dynatron, a three-roll mill, and a pressure kneader. The details are described in Saishin Ganryo Ohyo Gijutsu (Current Pigment Application Technologies), published by CMC Publishing Co., Ltd. (1986).

In the case where the photosensitive composition of the invention is applied to a lithographic printing plate precursor, the infrared absorber may be added in the same layer as in other components or may be added in a layer separately provided. In preparing a negative working printing plate precursor, the infrared absorber is added in such a manner that the absorbance at the maximum absorption wavelength in the wavelength range of the photosensitive layer of from 760 nm to 1,200 nm is in the range of from 0.5 to 1.2, and preferably from 0.6 to 1.15 by the reflectivity measurement method.

The absorbance of the photosensitive layer can be adjusted according to the amount of the infrared absorber to be added in the photosensitive layer and the thickness of the photosensitive layer. The measurement of the absorbance can be carried out by customary manners. Examples of the measurement method include a method in which a photosensitive layer having a thickness properly determined within the necessary range of the coating amount after drying as a lithographic printing plate is formed on a reflective support such as aluminum, the reflection density of which is then measured using an optical densitometer; and a method in which the absorbance is measured using a spectrophotometer by the reflection method using an integrating sphere.

The specific infrared absorber according to the invention must be contained in the photosensitive layer so as to control the foregoing absorbance ($OD_Y$) within a prescribed range. Usually, the infrared absorber is preferably added in an amount in the range of from 0.5 to 6 % by weight, more preferably from 1.0 to 5.0 % by weight, and further preferably from 1.5 to 4.0 % by weight based on the whole of components of the photosensitive layer.

(Polymerizable compound)

The polymerizable compound that is used in the photosensitive composition of the invention is an addition polymerizable compound containing at least one ethylenically unsaturated double bond and is selected from compounds containing at least one, and preferably two or more ethylenically unsaturated bonds. A group of such compounds is widely known in the subject industrial field, and these compounds can be used in the invention without particular limitations. These compounds have a chemical form of, for example, a monomer or a prepolymer, that is, a dimer, a trimer, and an oligomer, or a mixture or copolymer thereof. Examples of monomers and copolymers thereof include unsaturated carboxylic acids (such as acrylic acid, methacrylic acid, itaconic acid, crotonic acid, isocrotonic acid, and maleic acid) and esters and amides thereof; and preferably esters between an unsaturated carboxylic acid and an aliphatic polyhydric alcohol compound and amides between an unsaturated carboxylic acid and an aliphatic polyhydric amine compound. Also, addition reaction products of an unsaturated carboxylic acid ester or amide containing a nucleophilic substituent (such as a hydroxyl group, an amino group, and a mercapto group) with a monofunctional or polyfunctional isocyanate

or epoxy, and dehydration condensation reaction products thereof with a monofunctional or polyfunctional carboxylic acid are also suitably used. Also, addition reaction products of an unsaturated carboxylic acid ester or amide containing an electrophilic substituent (such as an isocyanate group and an epoxy group) with a monofunctional or polyfunctional alcohol, amine or thiol, and displacement reaction products of an unsaturated carboxylic acid ester or amide containing an eliminating substituent (such as a halogen group and a tosyloxy group) with a monofunctional or polyfunctional alcohol, amine or thiol are also suitable. Also, it is possible to use a group of compounds in which the foregoing unsaturated carboxylic acid is replaced by an unsaturated sulfonic acid, styrene, vinyl ether, etc.

Specific examples of monomers of the ester of an aliphatic polyhydric alcohol compound and an unsaturated carboxylic acid are as follows. Examples of acrylic acid esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis-[p-(3-methacryloxy-2-hydroxypropoxy)phenyl] dimethylmethane, and bis[p-(methacryloxyethoxy)phenyl]dimethylmethane.

Examples of itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of crotonic acid esters include ethylene glycol dicrotonate, tetramethylene glycol dicrotonate, pentaerythritol dicrotonate, and sorbitol tetradicrotonate.

Examples of isocrotonic acid esters include ethylene glycol diisocrotonate, pentaerythritol diisocrotonate, and sorbitol tetraisocrotonate.

Examples of maleic acid esters include ethylene glycol dimaleate, triethylene glycol dimaleate, pentaerythritol dimaleate, and sorbitol tetramaleate.

As other examples of esters, aliphatic alcohol based esters described in JP-B-46-27926, JP-B-51-47334, and JP-A-57-196231; esters having an aromatic skeleton described in JP-A-59-5240, JP-A-59-5241, and JP-A-2-226149; and esters containing an amino group described in JP-A-1-165613 are also suitably used. Further, the foregoing ester monomers can be used as a mixture.

Also, examples of monomers of the amide between an aliphatic polyhydric amine compound and an unsaturated carboxylic acid include methylenebis-acrylamide, methylenebis-methacrylamide, 1,6-hexaethylenebis-acrylamide, 1,6-hexamethylenebis-methacrylamide, diethylenetriamine trisacrylamide, xylylenebisacrylamide, and xylylenebismethacrylamide. As other preferred examples of amide based monomers, ones having a cyclohexylene structure as described in JP-B-54-21726 can be enumerated.

Also, urethane based addition polymerizable compounds produced using addition reaction between an isocyanate and a hydroxyl group are suitable. As specific examples, vinyl urethane compounds containing two or more polymerizable vinyl groups in one molecule, which are prepared by adding a hydroxyl group-containing vinyl monomer represented by the following formula (1) to a polyisocyanate compound containing two or more isocyanate groups in one molecule, as described in JP-B-48-41708, are enumerated.

<u>Formula (1)</u> $CH_2{=}C(R_4)COOCH_2CH(R_5)OH$

In the formula, $R_4$ and $R_5$ each represents H or $CH_3$.

Also, urethane acrylates described in JP-A-51-37193, JP-B-2-32293, and JP-B-2-16765; and urethane compounds having an ethylene oxide based skeleton described in JP-B-58-49860, JP-B-56-17654, JP-B-62-39417, and JP-B-62-39418 are suitable. Further, by using a polymerizable compound having an amino structure or a sulfide structure in the molecule described in JP-A-63-277653, JP-A-63-260909, and JP-A-1-105238, it is possible to obtain a polymerizable composition having very excellent photosensitive speed.

Other examples include polyester acrylates and polyfunctional acrylates or methacrylates of epoxy acrylates obtained by reacting an epoxy resin and (meth)acrylic acid, as described in JP-A-48-64183, JP-B-49-43191, and JP-B-52-30490. Also, specific unsaturated compounds described in JP-B-46-43946, JP-B-1-40337, and JP-B-1-40336; and vinyl phosphonic acid based compounds described in JP-A-2-25493 can be enumerated. Also, in some cases, compounds having a perfluoroalkyl group-containing structure described in JP-A-61-22048 are suitably used. Further, compounds introduced as photocurable monomers or oligomers in Journal of The Adhesion Society of Japan, Vol. 20, No. 7, pp. 300-308 (1984) can be used.

With respect to these polymerizable compounds, the details of the use method including their structures, single use or combined use, and addition amount can be arbitrarily set up depending upon the ultimate performance design. For example, selection is made from the following viewpoints. From the standpoint of photosensitive speed, a structure wherein the unsaturated group content per molecule is high is preferable, and in many cases, bifunctional or polyfunctional compounds are preferable. Also, for the sake of enhancing the strength in an image area, i.e., a cured film, trifunctional or polyfunctional compounds are preferable. Further, a method in which both of sensitivity speed and film strength are adjusted by jointly using compounds having a different functionality and a different polymerizable group (such as acrylic acid esters, methacrylic acid esters, styrene based compounds, and vinyl ether based compounds) is effective. Though compounds having a high molecular weight or compounds having high hydrophobicity are excellent in photosensite speed and film strength, they may possibly be undesired from the standpoints of development speed and deposition in the developing solution. Also, with respect to affinity with or dispersibility in other components in the recording layer (such as a binder polymer, an initiator, and a coloring agent), selection and use methods of addition polymerizable compounds are important factors. For example, the affinity may possibly be enhanced by using a low-purity compound or jointly using two or more kinds of the compounds.

Also, in the case of the photosensitive composition is applied to a lithographic printing plate precursor, for the purpose of enhancing adhesion to a substrate or an overcoat layer described later, a specific structure can be selected.

With respect to a compounding ratio of the addition polymerizable compound in the composition, a high compounding ratio is advantageous from the standpoint of sensitivity. In the case where the compounding ratio is too high, undesirable phase separation may possibly occur, problems in the manufacturing step due to adhesiveness of the photosensitive layer in applying it to a lithographic printing plate precursor (such as transfer of the photosensitive layer components and manufacturing failure derived from adhesion) may possibly be caused, and a problem such as deposition from the developing solution may possibly be caused. From these viewpoints, the addition polymerizable compound is preferably used in an amount ranging from 5 to 80 % by weight, and more preferably from 25 to 75 % by weight based on the non-volatile components in the composition. The addition polymerizable compound may be used singly or in admixture of two or more thereof. Besides, with respect to the use method of the addition polymerizable compound, adequate structure, compounding and addition amount can be arbitrarily selected from the viewpoints of degree of polymerization inhibition against oxygen, resolution, fogging properties, change in refractive index, surface adhesiveness, etc. Further, in the case where the photosensitive composition is applied to a lithographic printing plate precursor, a layer construction or coating method such as undercoating and overcoating can be carried out.

(Binder polymer)

In the invention, for the purpose of enhancing the film characteristics of the photosensitive layer to be formed, a binder polymer is used as an essential component. As the binder polymer, linear organic polymers are preferable for use. As such "linear organic polymers", known ones can be arbitrarily used. Preferably, in order to make it possible to undergo water development or weakly alkaline water development, linear organic polymers that are soluble in or swelling with water or weakly alkaline water are chosen. The linear organic polymer is selected and used according to the applications as not only a film forming agent for forming the photosensitive layer but also as a water, weakly alkaline water or organic solvent developer. For example, when a water-soluble organic polymer is used, it is possible to undergo water development. Examples of such linear organic polymers include radical polymers having a carboxylic acid group in the side chains thereof, as described in, for example, JP-A-59-44615, JP-B-54-34327, JP-B-58-12577, JP-B-54-25957, JP-B-54-92723, JP-A-59-53836, and JP-A-59-71048, that is, methacrylic acid copolymers, acrylic acid copolymers, itaconic acid copolymers, crotonic acid copolymers, maleic acid copolymers, partially esterified maleic acid copolymers, and the like. Also, acidic cellulose derivatives having a carboxylic acid group in the side chains thereof are enumerated. Besides, hydroxyl group-containing polymers to which a cyclic acid anhydride has been added are useful.

In particular, (meth)acrylic resins having a benzyl group or an allyl group and a carboxyl group in the side chains thereof are excellent in balance among film strength, sensitivity and developability and therefore, are suitable.

Also, acid group-containing urethane based binder polymers described in JP-B-7-12004, JP-B-7-120041, JP-B-7-120042, JP-B-8-12424, JP-A-63-287944, JP-A-63-287947, JP-A-1-271714, and JP-A-13-312062 are very excellent in strength and therefore, are advantageous from the standpoints of printing resistance of low-exposure adaptability.

Further, as other water-soluble linear organic polymers, polyvinylpyrrolidone and polyethylene oxide are useful. Also, for the sake of increasing the strength of the cured film, alcohol-soluble nylons and polyester between 2,2-bis-(4-hydroxyphenyl)-propane and epichlorohydrin are useful.

With respect to the polymer to be used in the invention, its weight average molecular weight is preferably 5,000 or more, and more preferably in the range of from 10,000 to 300,000; and its number average molecular weight is preferably 1,000 or more, and more preferably in the range of from 2,000 to 250,000. Its degree of polydispersion (weight

average molecular weight/number average molecular weight) is preferably 1 or more, and more preferably in the range of from 1.1 to 10.

While the polymer may be any of a random polymer, a block polymer, or a graft polymer, it is preferably a random polymer.

The binder polymer used in the invention can be synthesized by the conventionally known methods. Examples of solvents that are used in the synthesis include tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, methyl lactate, ethyl lactate, dimethyl sulfoxide, and water. The solvent is used singly or in admixture of two or more thereof.

Examples of radical polymerization initiators that are used in synthesizing the polymer to be used in the invention include known compounds such as azo based initiators and peroxide initiators.

The binder polymer to be used in the invention may be used singly or in admixture of two or more thereof. The polymer is added in an amount of from 20 to 95 % by weight, and preferably from 30 to 90 % by weight based on the whole of solids of the coating solution for photosensitive layer from the viewpoint of image forming property. Also, it is preferable that a weight ratio of the radical polymerizable compound containing at least one ethylenically unsaturated double bond to the linear organic polymer is in the range of from 1/9 to 7/3.

In the photosensitive composition of the invention, in addition to the foregoing essential components, other components suited for applications, manufacturing method, etc. can further be properly added. Preferred additives will be enumerated below.

(Polymerization inhibitor)

In the invention, for preventing unnecessary heat polymerization of the polymerizable compound from occurrence, it is desired to add a small amount of a heat polymerization inhibitor. Suitable examples of heat polymerization inhibitors include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), and N-nitroso-N-phenylhydroxylamine cerium(III) salt. The addition amount of the heat polymerization inhibitor is from about 0.01 to about 5 % by weight on a basis of the weight of non-volatile components in the whole of the composition.

Also, if desired, for preventing polymerization hindrance by oxygen, a higher fatty acid derivative such as behenic acid and behenic amide may be added such that it is made locally present on the surface of the recording layer during drying step after coating. The addition amount of the higher fatty acid derivative is preferably from about 0.5 % by weight to about 10 % by weight of non-volatile components in the whole of the composition.

(Colorant)

In the photosensitive composition of the invention, dyes or pigments may be further added for the purpose of coloration. In this way, it is possible to enhance visibility after plate making or so-called proofing property such as adaptability to an image density analyzer. With respect to the colorant, since most of dyes cause a lowering of the sensitivity of a photopolymerization system photosensitive layer, use of a pigment is especially preferable as the colorant. Specific examples include pigments such as phthalocyanine based pigments, azo based pigments, carbon black, and titanium oxide; and dyes such as Ethyl Violet, Crystal Violet, azo based dyes, anthraquinone based dyes, and cyanine based dyes. The addition amount of the dye or pigment as the colorant is preferably from about 0.5 % by weight to about 5 % by weight of non-volatile components in the whole of the composition.

(Other additives)

Further, in the photosensitive composition of the invention, inorganic fillers may be added for the purpose of improving physical properties of the cured film. Besides, known additives such as plasticizers and sensitizers capable of enhancing ink acceptability of the surface of the recording layer may be added.

Examples of plasticizers include dioctyl phthalate, didodecyl phthalate, triethylene glycol dicaprylate, dimethylene glycol phthalate, tricresyl phosphate, dioctyl adipate, dibutyl sebacate, and triacetyl glycerin. In general, the plasticizer can be added in an amount of not more than 10 % by weight based on the total weight of the binder polymer and the addition polymerizable compound. Also, in a lithographic printing plate precursor described later, a UV initiator, a heat crosslinking agent, etc. for strengthening the effects of heating and exposure after development can be added for the purpose of enhancing the film strength (printing resistance).

The photosensitive composition of the invention can be suitably used as a photosensitive layer in the lithographic printing plate precursor of the invention described later.

[Lithographic printing plate precursor]

The lithographic printing plate precursor of the invention is a lithographic printing plate precursor comprising a support having a photosensitive layer and a protective layer successively laminated thereon, wherein the photosensitive layer contains the photosensitive composition of the invention. Such a lithographic printing plate precursor can be produced by dissolving a coating solution for photosensitive layer containing the photosensitive composition of the invention and components for a coating solution of a desired layer such as a protective layer in a solvent and coating the solution on a suitable support or interlayer.

(Photosensitive layer)

The photosensitive layer according to the invention is a heat polymerizable negative working photosensitive layer containing, as essential components, an infrared absorber, a borate compound (polymerization initiator), a polymerizable compound (also called "addition polymerizable compound"), a binder polymer, and a carboxylic acid compound. Such a heat polymerizable negative working photosensitive layer has a function in which the polymerization initiator is decomposed by heat or light to generate a radical, and the polymerizable compound causes polymerization reaction due to the generated radical.

Further, the lithographic printing plate precursor of the invention is especially suitable for plate making by direct drawing with laser light having a wavelength of from 300 to 1,200 nm and reveals high printing resistance and image forming property as compared with conventional lithographic printing plate precursors.

In providing the foregoing photosensitive layer, the foregoing photosensitive composition of the invention is dissolved in a variety of organic solvents, and the solution is coated on a support or interlayer. Examples of the solvent to be used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate. The solvent can be used singly or in admixture. The concentration of the solid components in the coating solution is suitably from 2 to 50 % by weight.

It is desired to properly select the coating amount of the photosensitive layer according to the utility while mainly taking into consideration influences against sensitivity of the photosensitive layer, developability, strength and printing resistance of the exposed film, and the like. In the case where the coating amount is too low, the printing resistance is not sufficient. On the other hand, in the case where it is too high, the sensitivity lowers, it takes a time for exposure, and it takes a long period of time for the development processing, and therefore, such is not preferable. As a lithographic printing plate precursor for scanning exposure as the major object of the invention, the coating amount of the photosensitive layer is suitably in the range of from about 0.1 $g/m^2$ to about 10 $g/m^2$, and preferably from 0.5 to 5 $g/m^2$ in terms of weight after drying.

Incidentally, as physical properties of the photosensitive layer in the lithographic printing plate precursor, it is preferable that the rate of development in an unexposed area against an alkaline developing solution having a pH of from 10 to 13.5 is 80 nm/sec or more and that the rate of diffusion of the alkaline developing solution in an exposed area is not more than 100 nF/sec.

Here, the rate of development with an alkaline developing solution having a pH of from 10 to 13.5 is a value obtained by dividing the film thickness (m) of the photosensitive layer by the time (sec) required for the development; and the rate of diffusion of the alkaline developing solution is a value showing a change of electrostatic capacity (F) in the case where the foregoing photosensitive layer is provided on a conductive support and dipped in the developing solution.

The measurement methods of the "rate of development against alkaline developing solution" and "rate of diffusion of alkaline developing solution" in the invention will be described below in detail.

<Measurement of rate of development against alkaline developing solution>

Here, the rate of development of the photosensitive layer against an alkaline developing solution is a value obtained by dividing the film thickness (m) of the photosensitive layer by the time (sec) required for the development.

In the invention, with respect to the measurement method of the rate of development, as shown in Fig. 1, a lithographic printing plate precursor comprising an aluminum support having thereon an unexposed photosensitive layer was dipped in an alkaline developing solution (at 30 °C) having a fixed pH in the range of from 10 to 13.5, and the

dissolution behavior of the photosensitive layer was examined using a DRM interference wave analyzer. Fig. 1 is a schematic view of a DRM interference wave analyzer for measuring the dissolution behavior of the photosensitive layer. In the invention, a change of the film thickness was detected due to interference using light of 640 nm. In the case where the development behavior is non-swelling development from the photosensitive layer surface, the film thickness becomes gradually thin with the development time, whereby an interference wave is obtained corresponding to the thickness. Also, in the case of swelling dissolution (film-strippable dissolution), since the film thickness changes due to diffusion of the developing solution, a clear interference wave is not obtained.

The rate of development can be determined from the time when the measurement is continued under this condition, and the photosensitive layer is completely removed, whereby the film thickness becomes 0 (time of completion of development (s)), and the film thickness (μm) of the photosensitive layer according to the following equation. It is judged that when the rate of development is large, the film is easily removed by the developing solution so that the developability is good.

**[Rate of development (of unexposed area)] = {[Thickness of photosensitive layer (μm)]/[Time for completion of recording (sec)]}**

<Measurement of rate of diffusion of alkaline developing solution>

Also, the rate of diffusion of an alkaline developing solution is a value showing a change of electrostatic capacity (F) in the case where the foregoing photosensitive layer is provided on a conductive support and dipped in the developing solution.

In the invention, with respect to the measurement method of the electrostatic capacity as an index of the diffusibility, as shown in Fig. 2, a method in which in an alkaline developing solution (at 28 °C) having a fixed pH in the range of from 10 to 13.5, a lithographic printing plate precursor comprising an aluminum support having thereon a photosensitive layer, which has been exposed in a prescribed exposure amount and then cured, is dipped as one electrode, a lead wire is connected to the aluminum support, a usual electrode is used as the other electrode, and a voltage is applied is employable. After application of a voltage, the developing solution is diffused into the interface between the support and the photosensitive layer with a lapse of the dipping time, whereby the electrostatic capacity changes.

The rate of diffusion of the developing solution can be determined from the time (s) required until the electrostatic capacity changes and the film thickness (μm) of the photosensitive layer according to the following equation. It is judged that the smaller the rate of diffusion, the lower the diffusibility of the developing solution is.

**[Rate of diffusion of developing solution (of exposed area)] = {[Thickness of photosensitive layer (μm)]/[Time required until the change of electrostatic capacity becomes constant (s)]}**

With respect to preferred physical properties of the photosensitive layer in the lithographic printing plate precursor of the invention, the rate of development of an unexposed area with an alkaline developing solution having a pH of from 10 to 13.5 is preferably from 80 to 400 nm/sec, and more preferably from 90 to 200 nm/sec, and the rate of diffusion of the alkaline developing solution against the photosensitive layer is preferably not more than 90 nF/sec, and more preferably not more than 80 nF/sec, according to the foregoing measurements. The upper limit of the rate of development, or the lower limit of the rate of diffusion is not particularly limited, but taking into consideration balance therebetween, it is more preferable that the rate of development of the unexposed area is in the range of from 90 to 200 nm/sec and that the rate of diffusion of the alkaline developing solution against the photosensitive layer is not more than 80 nF/sec.

Control of the rate of development of the unexposed area of the photosensitive layer or of rate of diffusion of the alkaline developing solution against the photosensitive layer after curing can be carried out in customary manners. As representative methods, a measure of addition of a hydrophilic compound is useful for the sake of enhancing the

rate of development of the unexposed area, and a measure of addition of a hydrophobic compound is useful for the sake of controlling the diffusion of the developing solution into the exposed area.

By using the foregoing binder polymer according to the invention, it is possible to easily adjust the rate of development of the photosensitive layer and the rate of diffusion of the developing solution within the foregoing preferred ranges.

[Support]

As the support of the lithographic printing plate precursor of the invention, conventionally known hydrophilic supports that are used in lithographic printing plates can be used without limitations.

The support to be used is preferably in a dimensionally stable plate-like state. Examples include papers, papers laminated with plastics (such as polyethylene, polypropylene, and polystyrene), metal plates (such as aluminum, zinc, and copper), plastic films (such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, and polyvinyl acetal), and papers or plastic films laminated or vapor deposited with the foregoing metals. Also, the surface may be subjected to proper known physical or chemical processing for the purposes of imparting hydrophilicity and enhancing the strength as the need arises.

As the support, papers, polyester films, or aluminum plates are especially preferable. Above all, relatively cheap aluminum plates having good dimensional stability and capable of providing the surface having excellent hydrophilicity or strength by the surface processing, if desired are particularly preferable. Also, composite sheets comprising a polyethylene terephthalate film having an aluminum sheet bonded thereon as described in JP-B-48-18327 are preferable.

The aluminum plate is a metal plate containing dimensionally stable aluminum as the major component and is selected from pure aluminum plates, alloy plates containing aluminum as the major component and trace amounts of foreign elements, and plastic films or papers laminated or vapor deposited with aluminum (alloy). In the following description, a substrate made of the foregoing aluminum or aluminum alloy is named generally as "aluminum substrate". Examples of foreign elements contained in the foregoing aluminum alloys include silicon, iron, manganese, copper, magnesium, chromium, zinc, bismuth, nickel, and titanium. The content of foreign elements in the alloy is not more than 10 % by weight. In the invention, pure aluminum is particularly suitable. However, since it is difficult to produce completely pure aluminum from the standpoint of refining technology, those containing slightly foreign elements may be used. Aluminum plates that are applied in the invention are not specified with respect to their compositions, and those that have hitherto been known and used, as defined in, for example, JIS A1050, JIS A1100, JIS A3103, and JIS A3005, can be properly utilized.

Also, the aluminum support to be used in the invention has a thickness of from about 0.1 mm to 0.6 mm. This thickness can be properly changed depending upon the size of a printing machine, the size of a printing plate, and the desire of a user. The aluminum support may be properly subjected to surface processing of the support described later, if desired. As a matter of course, the aluminum support may not be subjected to such surface processing.

(Roughing processing)

Examples of the roughing processing include mechanical roughing, chemical etching, and electrolytic graining, as disclosed in JP-A-56-28893. Further, there are employable an electrochemical roughing method of electrochemically roughing the aluminum surface in a hydrochloric acid or nitric acid electrolytic liquid; and a mechanical roughing method such as a wire brushing method in which the aluminum surface is scratched by a metal wire, a ball graining method in which the aluminum surface is sandblasted using abrasive balls and an abrasive, and a brush graining method in which the aluminum surface is roughed using a nylon brush and an abrasive. The foregoing roughing methods can be employed singly or in combination. Of these, an electrochemical roughing method of electrochemically roughing the aluminum surface in a hydrochloric acid or nitric acid electrolytic liquid is useful for roughing. The quantity of electricity when the aluminum functions as an anode is suitably in the range of from 50 $C/dm^2$ to 400 $C/dm^2$. More specifically, it is preferable to carry out alternate current and/or direct current electrolysis in an electrolytic liquid containing from 0.1 to 50 % of hydrochloric acid or nitric acid under a condition at a temperature of from 20 to 80 ˚C for a period of time of from one second to 30 minutes and at a current density of from 100 $C/dm^2$ to 400 $C/dm^2$.

The aluminum support having been subjected to roughing processing may be chemically etched with an acid or alkali. Examples of etching agents that are suitably used include sodium hydroxide, sodium carbonate, sodium aluminate, sodium metasilicate, sodium phosphate, potassium hydroxide, and lithium hydroxide. It is preferable that the concentration and temperature ranges are from 1 to 50 % and from 20 to 100 ˚C, respectively. For the sake of removing residual smuts on the surface after etching, acid cleaning is carried out. Examples of the acid that can be used include nitric acid, sulfuric acid, phosphoric acid, chromic acid, hydrofluoric acid, and borofluoric acid. In particular, as desmutting processing after the electrochemical roughing processing, a method of contacting with from 15 to 65 % by weight of

sulfuric acid at a temperature of from 50 to 90 ˚C described in JP-A-53-12739 and a method of undergoing alkaline etching described in JP-B-48-28123 are preferable. After the processing, so far as the center line average roughness (Ra) is from 0.2 to 0.5 μm, there are no particular limitations with respect to the method and conditions.

(Anodic oxidation processing)

In general, the aluminum support on which the thus processed oxide layer has been formed is subsequently subjected to anodic oxidation processing.

In the anodic oxidation processing, an aqueous solution of sulfuric acid, phosphoric acid, oxalic acid, or boric acid/sodium borate is used singly or in combination of plural kinds as the major component of an electrolytic bath. In this regard, as a matter of course, the electrolytic liquid may contain at least components usually contained in an Al alloy plate, electrodes, tap water, ground water, or the like. Further, second and third components may be added to the electrolytic liquid. Examples of the second and third components as referred to herein include cations such as ions of metals (for example, Na, K, Mg, Li, Ca, Ti, Al, V, Cr, Mn, Fe, Co, Ni, Cu, and Zn) and an ammonium ion; and anions such as a nitric acid ion, a carbonic acid ion, a chlorine ion, a phosphoric acid ion, a fluorine ion, a sulfurous acid ion, a titanic acid ion, a silicic acid ion, and a boric acid ion, and the second and third components may be contained in a concentration of from about 0 to 10,000 ppm. The anodic oxidation processing condition is not particularly limited, but it is preferable that the anodic oxidation processing is carried out in a supply amount of from 30 to 500 g/liter at a processing temperature of from 10 to 70 ˚C and at a current density of from 0. 1 to 40 A/m$^2$ by direct current or alternating current electrolysis. The thus formed anodically oxidized film has a thickness in the range of from 0.5 to 1.5 μm, and preferably from 0.5 to 1.0 μm. The processing conditions can be chosen in such a manner that in the thus processed and prepared support, micro bores presented in the anodically oxidized film have a bore size in the range of from 5 to 10 nm and a bore density in the range of from $8 \times 10^{15}$ to $2 \times 10^{16}$ per square meter.

For hydrophilic processing of the surface of the support, widely known methods can be applied. Hydrophilic processing with a silicate or polyvinylphosphonic acid or the like is especially preferable. The film is formed in a coating amount of from 2 to 40 mg/m$^2$, and preferably from 4 to 30 mg/m$^2$ in terms of an Si or P element amount. The coating amount can be measured by the fluorescent X-ray analysis.

The foregoing hydrophilic processing is, for example, carried out by dipping the aluminum support having the anodically oxidized film formed thereon in an aqueous solution containing from 1 to 30 % by weight, and preferably from 2 to 15 % by weight of an alkali metal silicate or polyvinylphosphonic acid and having a pH at 25 ˚C of from 10 to 13 at from 15 to 80 ˚C for from 0.5 to 120 seconds.

Examples of the alkali metal silicate that can be used in the hydrophilic processing include sodium silicate, potassium silicate, and lithium silicate. Examples of hydroxides that are used for increasing the pH of the alkali metal silicate aqueous solution include sodium hydroxide, potassium hydroxide, and lithium hydroxide. Incidentally, the foregoing processing solution may be compounded with an alkaline earth metal salt or a salt of a metal belonging to the Group IVB. Examples of alkaline earth metal salts include nitric acid salts (for example, calcium nitrate, strontium nitrate, magnesium nitrate, and barium nitrate) and water-soluble salts (for example, sulfuric acid salts, hydrochloric acid salts, phosphoric acid salts, acetic acid salts, oxalic acid salts, and boric acid salts). Examples of salts of a metal belonging to the Group IVB include titanium tetrachloride, titanium trichloride, titanium fluoride potassium, titanium oxalate potassium, titanium sulfate, titanium tetraiodide, zirconium chloride oxide, zirconium dioxide, zirconium oxychloride, and zirconium tetrachloride.

The alkaline earth metal salt or salt of a metal belonging to the Group IVB can be used singly or in admixture of two or more thereof. The metal salt is preferably compounded in an amount in the range of from 0.01 to 10 % by weight, and more preferably from 0.05 to 5.0 % by weight. Also, silicate electrodeposition described in U.S. Patent No. 3,658,662 is effective. Surface processing comprising a combination of a support having been subjected to electrolytic graining described in JP-B-46-27481, JP-A-52-58602, and JP-A-52-30503 with the foregoing anodic oxidation processing and hydrophilic processing is also useful.

[Interlayer (undercoat layer)]

In the lithographic printing precursor of the invention, an interlayer (undercoat layer) may be provided for the purpose of improving adhesion or staining property between the photosensitive layer and the support. Specific examples of such an interlayer include those described in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-10-69092, JP-A-10-115931, JP-A-11-38635, JP-A-11-38629, JP-A-10-282645, JP-A-10-301262, JP-A-11-24277, JP-A-11-109641, JP-A-10-319600, JP-A-11-84674, JP-A-11-327152, JP-A-2000-10292, JP-A-2000-235254, JP-A-2000-352824, and JP-A-2001-209170.

[Protective layer (overcoat layer)]

In the invention, it is preferred to provide a protective layer on the photosensitive layer. Though the protective layer is basically provided for protecting the photosensitive layer, in the case where the photosensitive layer has a radical polymerizable image forming mechanism as in the invention, the protective layer plays a role as an oxygen shielding layer, and in the case where the photosensitive layer is exposed with infrared laser having a high luminance, the protective layer plays a role as an abrasion preventing layer.

Also, in addition to the foregoing roles, the protective layer is further required to have characteristics such that it does not substantially hinder permeation of light to be used for the exposure; that it has excellent adhesion to the photosensitive layer; and that it can be readily removed in the development step after the exposure. With respect to such protective layers, there have hitherto been made various devices, the details of which are described in U.S. Patent No. 3,458,311 and JP-B-55-49729.

As materials that can be used for the protective layer, water-soluble high-molecular compounds having relatively excellent crystallinity can be used. Specific examples thereof include water-soluble polymers such as polyvinyl alcohol, vinyl alcohol/vinyl phthalate copolymers, vinyl acetate/vinyl alcohol/vinyl phthalate copolymers, vinyl acetate/crotonic acid copolymers, polyvinylpyrrolidone, acidic celluloses, gelatin, gum arabic, polyacrylic acid, and polyacrylamides. These materials can be used singly or in admixture. Above all, use of polyvinyl alcohol as the major component gives the best results with respect to basic characteristics such as oxygen shielding property and development removal property.

The polyvinyl alcohol to be used in the protective layer may be partially substituted with an ester, an ether, or an acetal so far as it contains an unsubstituted vinyl alcohol unit for the sake of having necessary oxygen shielding property and water solubility. Also, the polyvinyl alcohol may partly have other copolymerization components.

Specific examples of the polyvinyl alcohol include those having been hydrolyzed to an extent of from 71 to 100 % by mole and having a weight average molecular weight in the range of from 300 to 2,400. Specific examples includes PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (all of which are manufactured by Kuraray Co., Ltd.).

Components of the protective layer (inclusive of selection of PVA and use of additives), coating amount, etc. are selected while taking into account oxygen shielding property, development removal property, fogging, adhesion, and scuff resistance. In general, the higher the degree of hydrolysis of PVA to be used (the higher the content of unsubstituted vinyl alcohol unit in the protective layer) and the thicker the film thickness, the higher the shielding property of low-molecular substances, therefore, such is advantageous on the point of sensitivity. However, where the oxygen shielding property is extremely increased, there are caused problems such that unnecessary polymerization reaction takes place at the time of manufacture and unprocessed stock storage and that unnecessary fogging and thickening of image lines are generated at the time of imagewise exposure.

Accordingly, it is preferable that the oxygen permeation (A) at 25 °C at 1 atm. is satisfied with the relation: $0.2 \le A \le 20$ ($cc/m^2 \cdot day$).

With respect to the foregoing (co)polymers such as polyvinyl alcohol (PVA), those having a molecular weight in the range of from 2,000 to 10,000,000, and preferably from 20,000 to 3,000,000 can be used.

As other composition of the protective layer, by adding glycerin, dipropylene glycol, or the like in an amount corresponding to several % by weight to the (co)polymer, it is possible to impart flexibility. Also, it is possible to add an anionic surfactant (for example, sodium alkylsulfates and sodium alkylsulfonates), an ampholytic surfactant (for example, alkylaminocarboxylic acid salts and alkylaminodicarboxylic acid salts), or a nonionic surfactant (for example, polyoxyethylene alkylphenyl ethers) in an amount of several % by weight to the (co)polymer.

The film thickness of the protective layer is suitably from 0.5 to 5 μm, and especially suitably from 0.5 to 2 μm.

Also, adhesion to an image area and scuff resistance are also extremely important in handling printing plates. That is, when a hydrophilic layer made of a water-soluble polymer is laminated on an oleophilic polymerization layer, film separation is liable to take place due to shortage of adhesive force, whereby the separated part causes defects such as poor film curing due to polymerization inhibition by oxygen. In this regard, various proposals have been made for improving the adhesion between these two layers. For example, it is known that by mixing from 20 to 60 % by weight of an acrylic emulsion or a water-insoluble polyvinylpyrrolidone-vinyl acetal copolymer in a hydrophilic polymer mainly composed of polyvinyl alcohol and laminating the mixture on a polymerization layer, sufficient adhesion is obtained. For the protective layer in the invention, any of these known technologies can be applied. Coating methods of such protective layers are described in detail in, for example, U.S. Patent No. 3,458,311 and JP-A-55-49729.

For the sake of plate making of a lithographic printing plate from the lithographic printing plate precursor of the invention, at least exposure and development processes are carried out.

As light sources for exposing the lithographic printing plate precursor of the invention, infrared lasers are suitable. Also, thermal recording can be carried out using an ultraviolet lamp or a thermal head.

Above all, in the invention, it is preferable that image exposure is carried out using solid lasers or semiconductor

lasers capable of radiating infrared light having a wavelength of from 750 nm to 1,400 nm. The output of the laser is preferably 100 mW or more, and for the sake of shortening the exposure time, it is preferable to use a multi-beam laser device. Also, it is preferable that the exposure time per pixel is within 20 μsec. Energy to be irradiated on the lithographic printing plate precursor is preferably from 10 to 300 mJ/cm$^2$. When the exposure energy is too low, curing of the image recording layer may not possibly proceed sufficiently. On the other hand, when the exposure energy is too high, the image recording layer is subjected to abrasion with laser, whereby the image may possibly be injured.

In the invention, exposure can be carried out by overlapping light beams as the light source. The overlap means that the sub-scanning pitch width is smaller than the beam size. For example, when the beam size is expressed in terms of full width at half maximum (FWHM), the overlap can be quantitatively expressed by FWHM/sub-scanning pitch width (overlap coefficient). In the invention, it is preferable that the overlap coefficient is 0.1 or more.

The scanning system of the light source of the exposure device that is used in the invention is not particularly limited, and a cylinder external surface scanning system, a cylinder internal surface scanning system, and a planar scanning system can be employed. Also, the channel of the light source may be of a single channel or multi-channel mode, but in the case of a cylinder external surface scanning system, a multi-channel mode is preferably employed.

In the invention, the development processing may be carried out immediately after the exposure, or heat treatment may be carried out between the exposure step and the development step. With respect to the heat treatment condition, it is preferable that the heat treatment is carried out at a temperature in the range of from 60 to 150 °C for from 5 seconds to 5 minutes.

The heat treatment can be properly chosen from a variety of the conventionally known methods. Specific examples thereof include a method of heating the lithographic printing plate precursor while bringing it into contact with a panel heater or ceramic heater; and a method of non-contact heating by a lamp or warm air. By undergoing the foregoing heat treatment, it is possible to reduce the amount of laser energy necessary for image recording in the laser to be irradiated.

Also, in the invention, pre-water washing for removing the protective layer may be carried out prior to the development step. For example, tap water is used for the pre-water washing.

The lithographic printing plate precursor of the invention is subjected to development processing after the exposure (or after the exposure and heating steps). As a developing solution to be used in the development processing, alkaline aqueous solutions having a pH of not more than 14 are especially preferable. More preferably, alkaline aqueous solution having a pH of from 8 to 12 and containing an anionic surfactant are used. Examples thereof include inorganic alkaline agents such as sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, ammonium hydroxide, potassium hydroxide, and lithium hydroxide. Also, organic alkaline agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine can be used. The alkaline agent is used singly or in combination of two or more thereof.

Also, in the development processing of the lithographic printing plate precursor of the invention, an anionic surfactant is usually added in an amount of from 1 to 20 % by weight, and preferably from 3 to 10 % by weight in the developing solution from the viewpoints of good developability and friction resistance of image.

Examples of anionic surfactants include a sodium salt of lauryl alcohol sulfate, an ammonium salt of lauryl alcohol sulfate, a sodium salt of octyl alcohol sulfate, alkyl-arylsulfonic acid slats (for example, a sodium salt of isopropylnaphthalenesulfonic acid, a sodium salt of isobutylnaphthalenesulfonic acid, a sodium salt of polyoxyethylene glycol mononaphthyl ether sulfuric acid ester, a sodium salt of dodecylbenzenesulfonic acid, and a sodium salt of m-nitrobenzenesulfonic acid), sulfuric acid esters of a higher alcohol having from 8 to 22 carbon atoms (for example, secondary sodium alkyl sulfates), aliphatic alcohol phosphoric acid esters (for example, a sodium salt of cetyl alcohol phosphoric acid ester), sulfonic acid salts of an alkylamide (for example, $C_{17}H_{33}CON(CH_3)CH_2CH_2SO_3Na$), and sulfonic acid salts of a dibasic aliphatic ester (for example, sodium sulfosuccinic acid dioctyl ester and sodium sulfosuccinic acid dihexyl ester).

Also, an organic solvent capable of being mixed with water, such as benzyl alcohol, may be added to the developing solution, if desired. As the organic solvent, those having a solubility in water of not more than about 10 % by weight, and preferably not more than 5 % by weight are chosen. Examples thereof include 1-phenylethanol, 2-phenylethanol, 3-phenylpropanol, 1,4-phenylbutanol, 2,2,-phenylbutanol, 1,2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 4-methylcyclohexanol, and 3-methylcyclohexanol. The content of the organic solvent is suitably from 1 to 5 % by weight based on the total weight of the developing solution at the time of use. Its use amount is closely related to the amount of the surfactant to be used, and it is preferred to increase the amount of the anionic surfactant with the

increase of the organic solvent. This is because when the amount of the organic solvent is increased in the state that the amount of the anionic surfactant is small, the organic solvent does not dissolve the anionic surfactant therein, and therefore, securance of good developability cannot be expected.

Also, additives such as a defoaming agent and a hard water softener may further be contained, if desired. Examples of hard water softeners include polyphosphoric acid salts (for example, $Na_2P_2O_7$, $Na_5P_3O_3$, $Na_3P_3O_9$, $Na_2O_4P(NaO_3P)PO_3Na$, and Calgon (poly(sodium metaphosphate))); amino polycarboxylic acids (for example, ethylenediaminetetraacetic acid and its potassium salt and sodium salt; diethylenetriaminepentaacetic acid and its potassium salt and sodium salt; triethylenetetraminehexaacetic acid and its potassium salt and sodium salt; hydroxyethyl ethylenediaminetriacetic acid and its potassium salt and sodium salt; nitrilotriacetic acid and its potassium salt and sodium salt; 1,2-diaminocyclohexanetetraacetic acid and its potassium salt and sodium salt; and 1,3-diamino-2-propanoltetraacetic acid and its potassium salt and sodium salt); other polycarboxylic acids (for example, 2-phosphonobutanetricarboxylic acid-1,2,4 and its potassium salt and sodium salt; and 2-phosphobutanonetricarboxylic acid-2,3,4 and its potassium salt and sodium salt); and organic phosphonic acids (for example, 1-phosphonoethanetricarboxylic acid-1,2,2 and its potassium salt and sodium salt; 1-hydroxyethane-1,1-diphosphonic acid and its potassium salt and sodium salt; and aminotri-(methylenephosphonic acid) and its potassium salt and sodium salt). The optimum amount of the hard water softener varies depending upon the hardness of hard water to be used and its use amount, but the hard water softener is generally used in an amount in the range of from 0.01 to 5 % by weight, and preferably from 0.01 to 0.5 % by weight in the developing solution at the time of use.

Further, in the case where the lithographic printing plate precursor is developed using an automatic processor, since the developing solution fatigues corresponding to the processing amount, a processing ability may be recovered using a replenisher or fresh developing solution. In this case, it is preferable to carry out the replenishment by the method described in U.S. Patent No. 4,882,246. Also, developing solutions described in JP-A-50-26601, JP-A-58-54341, JP-B-56-39464, JP-B-56-42860, and JP-B-57-7427 are preferable.

The lithographic printing plate precursor thus developed may be subjected to post treatment with, for example, washing water, a rinse solution containing a surfactant, etc., and a desensitizing solution containing gum arabic or starch derivatives as described in JP-A-54-8002, JP-A-55-115045, and JP-A-59-58431. In the post treatment of the lithographic printing plate precursor of the invention, these treatments can be employed through a variety of combinations.

In plate making of the lithographic printing plate precursor of the invention, for the purpose of enhancing the image strength and printing resistance, it is effective to undergo entire post heating or entire exposure against an image after the development.

A very strong condition can be applied to heating after the development. In general, the heat treatment is carried out at a temperature in the range of from 200 to 500 ˚C. When the heating temperature after the development is too low, a sufficient image-reinforcing action cannot be obtained. On the other hand, when it is too high, problems such as deterioration of the support and heat decomposition of the image area may possibly occur.

The lithographic printing plate obtained through the foregoing processings is fixed in an offset printing machine and used for producing a number of prints.

As a plate cleaner that is used for the purpose of removing smuts on the plate at the time of printing, conventionally known plate cleaners for PS plate are employed, and examples thereof include CL-1, CL-2, CP, CN-4, CN, CG-1, PC-1, SR, and IC (all of which are manufactured by Fuji Photo Film Co., Ltd.).

## EXAMPLES

The invention will be described below with reference to the following Examples, but it should not be construed that the invention is limited thereto.

[Examples 1 to 6 and Comparative Examples 1 to 2]

[Preparation of support]

A molten metal was prepared using an aluminum alloy containing 0.06 % by weight of Si, 0.30 % by weight of Fe, 0.001 % by weight of Cu, 0.001 % by weight of Mn, 0.001 % by weight of Mg, 0.001 % by weight of Zn, and 0.03 % by weight of Ti, with the remainder being Al and inevitable impurities, subjected to molten metal treatment, and then filtered. An ingot having a thickness of 500 mm and a width of 1,200 mm was then prepared by DC casting. The surface was shaved in a thickness of 10 mm in average by using a facing machine and then subjecting to soaking at 550 ˚C for about 5 hours. When the temperature lowered to 400 ˚C, the resulting ingot was formed into a rolled plate having a thickness of 2.7 mm using a hot rolling machine. Further, after heat treatment at 500 ˚C using a continuous annealing machine, the resulting rolled plate was finished so as to have a thickness of 0.24 mm by means of cold rolling, to obtain an aluminum plate according to JIS A1050. This aluminum plate was formed into a width of 1,030 mm and then subjected

to the following surface processing.

<Surface processing>

The surface processing was carried out by continuously performing the following processings (a) to (j). Incidentally, after each processing and water washing, draining was carried out using nip rollers.

(a) Mechanical roughing processing:

Using a device shown in Fig. 3, the aluminum plate was subjected to mechanical roughing processing by a rotating roller-state nylon brush while supplying a suspension consisting of an abrasive (pumice) and water and having a specific gravity of 1.12 as a polishing slurry liquid onto the surface of the aluminum plate. In Fig. 3, 1 denotes an aluminum plate; 2 and 4 each denotes a roller-state brush; 3 denotes a polishing slurry liquid; and 5, 6, 7 and 8 each denotes a supporting roller. The abrasive had a mean particle size of 30 μm and a maximum particle size of 100 μm. The nylon brush was made of 6/10-nylon and had a hair length of 45 mm and a hair diameter of 0.3 mm. The nylon brush was one prepared by providing bores on a stainless steel-made φ300 mm-cylinder and closely planting nylon hairs in the bores. Three rotary brushes were used. A distance between the two supporting rollers (φ200 mm) beneath the brush was 300 mm. The brush roller was pressed until a load of a drive motor for rotating the brush roller became 7 kW plus with respect to a load prior to pressing the brush roller against the aluminum plate. The rotation direction of the brush was identical with the transfer direction of the aluminum plate. The number of rotation of the brush was 200 rpm.

(b) Alkaline etching processing:

The resulting aluminum plate was subjected to etching processing by spraying an aqueous solution having a sodium hydroxide concentration of 2.6 % by weight and an aluminum ion concentration of 6.5 % by weight and having a temperature of 70 ˚C, thereby dissolving 10 $g/m^2$ of the aluminum plate. Thereafter, the aluminum plate was washed with water by spraying.

(c) Desmutting processing:

The aluminum plate was subjected to desmutting processing by spraying an aqueous solution having a nitric acid concentration of 1 % by weight (containing 0.5 % by weight of an aluminum ion) and having a temperature of 30 ˚C, followed by washing with water by spraying. As the nitric acid aqueous solution used in the desmutting processing, a waste liquor in a step of electrochemical roughing processing using an alternating current in the nitric acid aqueous solution was used.

(d) Electrochemical roughing processing:

Electrochemical roughing processing was continuously carried out using an alternating voltage of 60 Hz. At this time, the used electrolytic liquid was an aqueous solution containing 10.5 g/L of nitric acid (containing 5 g/L of an aluminum ion and 0.007 % by weight of an ammonium ion) and having a liquid temperature of 50 ˚C. The alternating current power source waveform is a waveform shown in Fig. 4, and the electrochemical roughing processing was carried out using a carbon electrode as a counter electrode and using a trapezoid rectangular wave alternating current having a time (TP) of from zero to a peak of the current value of 0.8 msec and a duty ratio of 1/1. Ferrite was used as an auxiliary anode. An electrolytic cell shown in Fig. 5 was used.

The current density was 30 $A/dm^2$ in terms of the peak value of current, and the quantity of electrification was 220 $C/dm^2$ in terms of total sum of quantities of electrification when the aluminum plate functioned as an anode. For the auxiliary anode, 5 % of the current having passed from the power source was shunted. Thereafter, the aluminum plate was washed with water by spraying.

(e) Alkaline etching processing:

The aluminum plate was subjected to etching processing at 32 ˚C by spraying an aqueous solution having a sodium hydroxide concentration of 26 % by weight and an aluminum ion concentration of 6.5 % by weight, thereby dissolving 0.50 $g/m^2$ of the aluminum plate and removing smut components mainly composed of aluminum hydroxide formed when the preceding electrochemical roughing processing was carried out using an alternating current. Also, an edge portion of the formed pit was dissolved, thereby smoothening the edge portion. Thereafter, the aluminum plate was washed with water by spraying.

(f) Desmutting processing:

The aluminum plate was subjected to desmutting processing by spraying an aqueous solution having a nitric acid concentration of 15 % by weight (containing 4.5 % by weight of an aluminum ion) and having a temperature of 30 ˚C, followed by washing with water by spraying. As the nitric acid aqueous solution used in the desmutting processing, a waste liquor in a step of electrochemical roughing processing using an alternating current in the nitric acid aqueous solution was used.

(g) Electrochemical roughing processing:

Electrochemical roughing processing was continuously carried out using an alternating voltage of 60 Hz. At this time, the used electrolytic liquid was an aqueous solution containing 5.0 g/L of hydrochloric acid (containing 5 g/L of an aluminum ion) and having a temperature of 35 ˚C. The alternating current power source waveform is a waveform shown in Fig. 4, and the electrochemical roughing processing was carried out using a carbon electrode as a counter electrode and using a trapezoid rectangular wave alternating current having a time (TP) of from zero to a peak of the current value of 0.8 msec and a duty ratio of 1/1. Ferrite was used as an auxiliary anode. An electrolytic cell shown in Fig. 5 was used.

The current density was 25 $A/dm^2$ in terms of the peak value of current, and the quantity of electrification was 50 $C/dm^2$ in terms of total sum of quantities of electrification when the aluminum plate functioned as an anode. Thereafter, the aluminum plate was washed with water by spraying.

(h) Alkaline etching processing:

The aluminum plate was subjected to etching processing at 32 ˚C by spraying an aqueous solution having a sodium hydroxide concentration of 26 % by weight and an aluminum ion concentration of 6.5 % by weight, thereby dissolving 0.10 $g/m^2$ of the aluminum plate and removing smut components mainly composed of aluminum hydroxide formed when the preceding electrochemical roughing processing was carried out using an alternating current. Also, an edge portion of the formed pit was dissolved, thereby smoothening the edge portion. Thereafter, the aluminum plate was washed with water by spraying.

(i) Desmutting processing:

The aluminum plate was subjected to desmutting processing by spraying an aqueous solution having a sulfuric acid concentration of 15 % by weight (containing 0.5 % by weight of an aluminum ion) and having a temperature of 60 ˚C, followed by washing with water by spraying.

(j) Anodic oxidation processing:

The aluminum plate was subjected to anodic oxidation processing using an anodic oxidation device having a structure shown in Fig. 6, to obtain a support for lithographic printing plate. Sulfuric acid was used as an electrolytic liquid to be supplied in first and second electrolysis sections. All of the electrolytic liquids had a sulfuric acid concentration of 170 g/L (containing 0.5 % by weight of an aluminum ion) and a temperature of 38 ˚C. Thereafter, the aluminum plate was washed with water by spraying. An amount of the finally oxidized film was 2.7 $g/m^2$.

The support obtained through the foregoing processings had an Ra of 0.45.

[Undercoating]

Next, the following undercoating solution was coated on the aluminum support using a wire bar and dried at 90 ˚C for 30 seconds using a warm air drying device. The coating amount after drying was 10 $mg/m^2$.

<Undercoating solution>

- Methyl acrylate/ethyl acrylate/sodium 0.1 g 2-acrylamido-2-methyl-1-propanesulfonate copolymer (molar ratio: 70/15/15)
- 2-Aminoethylphosphonic acid: 0.1 g
- Methanol: 50 g

- Ion-exchanged water: 50 g

[Photosensitive layer]

Next, the following coating solution for photosensitive layer [P-1] was prepared and coated on the foregoing undercoated aluminum plate using a wire bar. Drying was carried out at 122 °C for 43.5 seconds using a warm air drying device, to form a photosensitive layer. The coating amount after drying was 1.4 g/m$^2$.

<Coating solution for photosensitive layer [P-1]>

- Infrared absorber (IR-1): 0.08 g
- Polymerization initiator according to the 0.25 g invention:
- Dipentaerythritol hexaacrylate: 1.00 g
- Binder polymer (BT-1): 1.00 g
- Chloride salt of Ethyl Violet: 0.04 g
- Fluorine based surfactant (Megaface F-780-F, 0.03 g manufactured by Dainippon Ink and Chemicals, Incorporated):

  - Carboxylic acid compound according to the (Amount shown in Table 1) invention:

    - Methyl ethyl ketone: 10.4 g
    - Methanol: 4.83 g
    - 1-Methoxy-2-propanol: 10.4 g

The structures of the infrared absorber (IR-1), polymerization initiators (OS-1) to (OS-4), and binder polymer (BT-1) used in the foregoing coating solution for photosensitive layer are shown below.

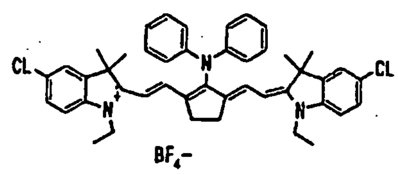

Infrared Absorber (IR-1)

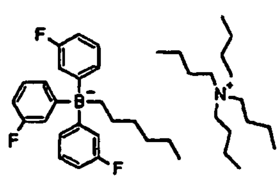

Polymerization Initiator (OS-1)

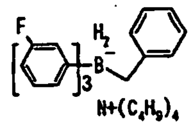

Polymerization Initiator (OS-2)

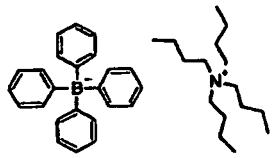

Polymerization Initiator (OS-3)

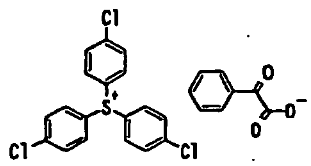

Polymerization Initiator (OS-4)

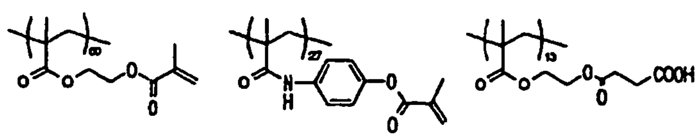

Binder Polymer (BT-1)

[Protective layer]

A mixed aqueous solution of polyvinyl alcohol (degree of hydrolysis: 98 % by mole, degree of polymerization: 500) and polyvinylpyrrolidone (Luviscol K-30, manufactured by BASF Corporation) was coated on the surface of the foregoing photosensitive layer using a wire bar and dried at 125 °C for 75 seconds using a warm air drying device. The content of PVA was 85 % by weight, and the coating amount (after drying) was 2.45 g/m$^2$. The surface had a coefficient of dynamic friction of 0.45.

There were thus obtained lithographic printing plate precursors of Examples 1 to 6 and Comparative Examples 1 to 2.

[Evaluation]

(1) Sensitivity evaluation:

Each of the thus obtained lithographic printing plate precursors was exposed using Creo's Trendsetter 3244VX mounted with a water-cooled 40-W infrared semiconductor laser at a resolution of 175 lpi and at a number of rotation of external drum of 150 rpm while changing an output by 0.15 in terms of log E within the range of from 0 to 8 W. Incidentally, the exposure was carried out under a condition at 25 ˚C and at a 50 % RH. After the exposure, the protective layer was removed by washing with tap water, and the residue was developed at 30 ˚C for 12 seconds using LP-1310HII manufactured by Fuji Photo Film Co., Ltd. A (1/4) water-diluted solution of DV-2 manufactured by Fuji Photo Film Co., Ltd. was used as a developing solution, and a (1/1) water-diluted solution of FP-2W manufactured by Fuji Photo Film Co., Ltd. was used as a finisher.

A density of an image area of the lithographic printing plate obtained by the development was measured as a cyan density using a Macbeth reflection densitometer RD-918 and using a red filter equipped in the densitometer. The inverse number of the exposure amount necessary for obtaining the measured density of 0.8 was defined as an index of the sensitivity. Incidentally, the evaluation was made in such a manner that the sensitivity of the lithographic printing plate obtained in Comparative Example 1 was defined as 100, and the sensitivity of each of other lithographic printing plates was evaluated as a relative value. The larger the value, the more excellent the sensitivity is. The results obtained are shown in Table 1.

(2) Unprocessed stock storability evaluation:

A lithographic printing plate precursor in the unexposed state was stored at 45 ˚C and 75 % RH for 3 days, exposed and developed in the following manner, and a density of a non-image area was measured using a Macbeth reflection densitometer RD-918. Also, with respect to a lithographic printing plate precursor immediately after the preparation, exposure and development were carried out in the same manner, and a density of a non-image area was measured. In these Examples, a difference (Δfog) in the density of non-image area therebetween was determined and defined as an index of the unprocessed stock storability. The smaller the Δfog value, the better the unprocessed stock storability is. Values of not more than 0.02 are at a level where there is no problem in the practical use. The results obtained are shown in Table 1.

(Exposure and development)

The lithographic printing plate precursor was exposed with a solid density image having a resolution of 175 lpi using Creo's Trendsetter 3244VX mounted with a water-cooled 40-W infrared semiconductor laser under conditions of an output of 8 W, a number of rotation of external drum of 206 rpm, and a plate surface energy of 100 $mJ/cm^2$. After the exposure, the protective layer was removed by washing with tap water, and the residue was developed in the same manner as in the development step of the foregoing sensitivity evaluation (1).

(3) Printing resistance evaluation:

The obtained lithographic printing plate precursor was exposed with an 80 % separated mesh image having a resolution of 175 lpi using Creo's Trendsetter 3244VX mounted with a water-cooled 40-W infrared semiconductor laser under conditions of an output of 8 W, a number of rotation of external drum of 206 rpm, and a plate surface energy of 100 $mJ/cm^2$. After the exposure, the protective layer was removed by washing with tap water, and the residue was developed in the same manner as in the development step of the foregoing sensitivity evaluation (1), to obtain a lithographic printing plate.

The resulting lithographic printing plate was printed using Lithrone (a printing machine, manufactured by Komori Corporation), and the number of sheets having been completed for printing was defined as an index. The results obtained are shown in Table 1.

Table 1

| | Carboxylic acid compound | | Polymerization initiator Compound No. | Sensitivity at 25 ˚C and 45%RH | Unprocessed stock storability Δfog | Printing resistance (number of sheets) |
|---|---|---|---|---|---|---|
| | Compound No. | Content (g) | | | | |
| Example 1 | 5 | 0.11 | OS-1 | 120 | ±0 | 100,000 |
| Example 2 | 1 | 0.08 | OS-1 | 115 | 0.01 | 100,000 |
| Example 3 | 8 | 0.09 | OS-2 | 130 | 0.02 | 120,000 |
| Example 4 | 9 | 0.12 | OS-1 | 120 | 0.02 | 120,000 |
| Example 5 | 17 | 0.15 | OS-3/OS-4* | 120 | 0.01 | 110,000 |
| Example 6 | 19 | 0.1 | OS-1 | 115 | 0.01 | 100,000 |
| Comparative Example 1 | No | - | OS-1 | 100 | 0.14 | 80,000 |
| Comparative Example 2 | No | - | - OS-2 | 110 | 0.23 | 70,000 |
| *: 0.25 g of each of OS-3 and OS-4 | | | | | | |

As is clear from Table 1, it was noted that the lithographic printing plate precursors of Examples 1 to 6 are excellent in all of sensitivity, unprocessed stock stability and printing resistance. On the other hand, it was noted that the lithographic printing plate precursors of Comparative Examples 1 and 2 are inferior in unprocessed stock stability and printing resistance and are at a level where there is some problem in the practical use.

[Example 7]

A lithographic printing plate precursor was prepared in the same manner as in Example 1, except that the dipentaerythritol hexaacrylate used in the coating solution for photosensitive layer [P-1] was replaced by the following ethylenically unsaturated bond-containing compound (M-1) and that the binder polymer (BT-1) was replaced by the following polyurethane resin binder (P-2). The resulting lithographic printing plate precursor was evaluated in the same manner as in Example 1. As a result of the evaluation, the sensitive was 125, the unprocessed stock stability (Δfog) was ±0, and the printing resistance was 130,000 sheets. Therefore, it was noted that the lithographic printing plate precursor of this Example was excellent in all of sensitivity, unprocessed stock stability and printing resistance.

Ethylenically Unsaturated Bond-Containing Compound

(M-1)

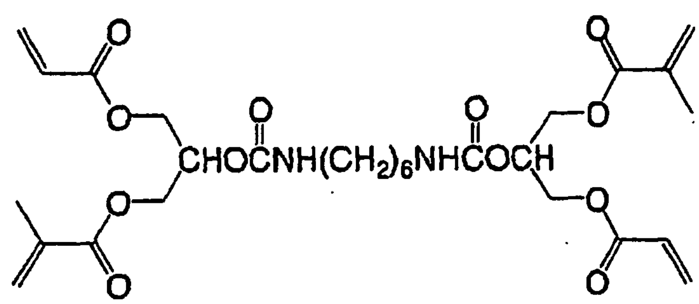

Polyurethane Resin Binder Polymer (P-2)

MDI / HMDI / PPG 1000 / DMPA = 40 / 10 / 11 / 39 mol%
Mw ≅ 55,000

MDI :

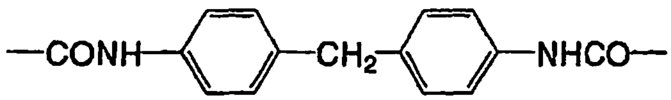

HMDI : $-CONH-(CH_2)_6-NHCO-$

PPG 1000 (Mw 1000) :

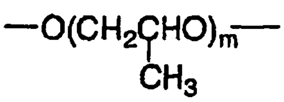

m ≒ 17

DMPA :

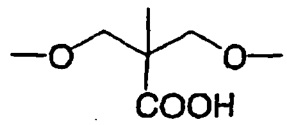

According to the invention, it is possible to provide a photosensitive composition having high sensitivity and good storage stability (unprocessed stock storability) and useful as a photosensitive layer of a negative working lithographic printing plate precursor. Also, it is possible to provide a negative working lithographic printing plate precursor capable of being recorded with high sensitivity by infrared laser and having excellent storage stability (unprocessed stock storability) and printing resistance.

## Claims

**1.** A photosensitive composition containing

(i) an infrared absorber,
(ii) a borate compound,
(iii) a polymerizable compound containing at least one ethylenically unsaturated double bond,
(iv)a binder polymer, and
(v) a compound having a weight average molecular weight of not more than 3,000 and containing at least one carboxylic acid group,

with the proviso that the following two compositions, wherein the borate compound (ii) is a compound of the following formula:

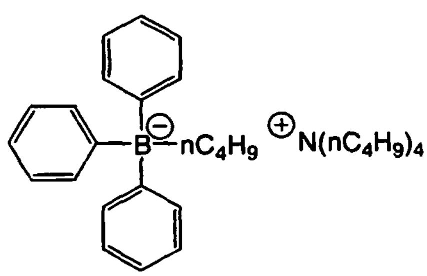

and the compound (v) is selected from the following two formulae:

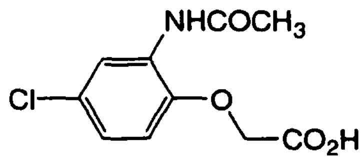

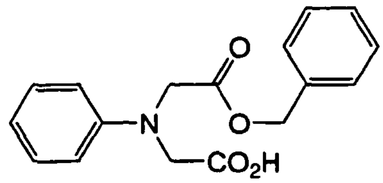

are excluded.

2. The photosensitive composition of claim 1, wherein the compound (v) contains two or more carboxylic acid groups or at least one acid group other than a carboxylic acid group.

3. The photosensitive composition of claim 1 or 2, wherein the weight average molecular weight of compound (v) is 60-2,000.

4. The photosensitive composition of any of claims 1-3, wherein the content of the compound (v) is 0.5-30 wt.-%, based on the whole solids content.

5. The photosensitive composition of any of claims 1-4, wherein compound (v) is selected from formulae (1)-(21):

1

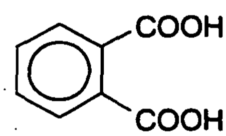

2

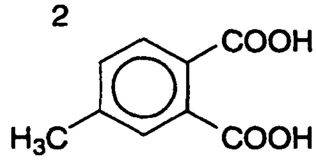

3

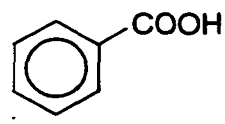

4

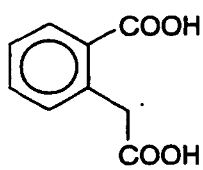

5

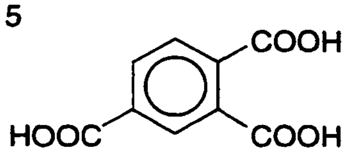

6

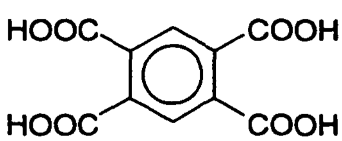

7

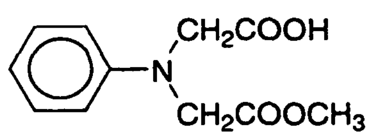

8

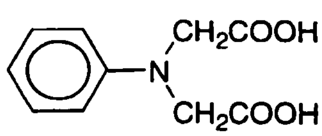

9

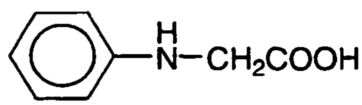

10

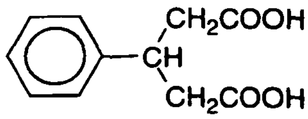

11

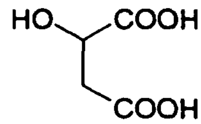

12

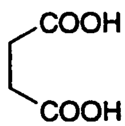

13

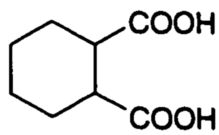

14

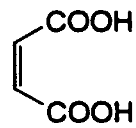

15

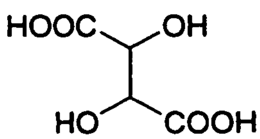

16

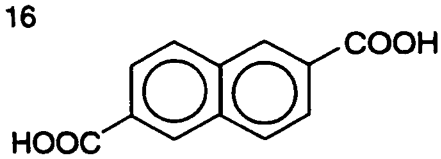

17

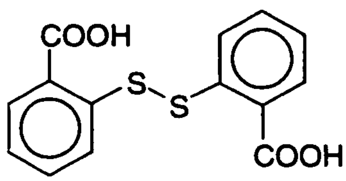

18

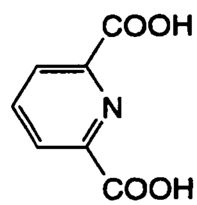

19

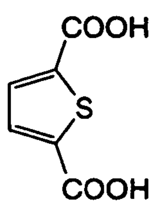

20

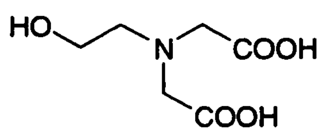

21

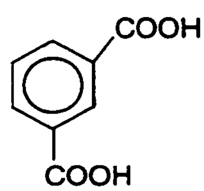

**6.** The photosensitive composition of any of claims 1-5, wherein the borate compound is a compound represented by the following formula (I):

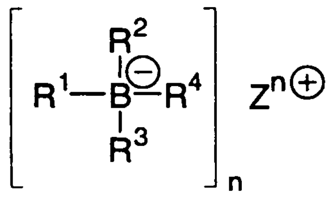

(I)

wherein

$R^1$, $R^2$, $R^3$, and $R^4$ each independently is an organic group, provided that at least one of $R^1$, $R^2$, $R^3$, and $R^4$ is an alkyl group;
$Z^{n+}$ is a cation having a valence of n; and
n is an integer of 1-6.

**7.** The photosensitive composition of claim 1, wherein the borate compound (ii) contains at least one phenyl group substituted with fluorine at a m-position thereof.

**8.** The photosensitive composition of claim 1, which further contains an onium salt.

**9.** A lithographic printing plate precursor comprising, in this order, a support, a photosensitive layer containing the photosensitive composition of any of claims 1-8, and a protective layer.

**Patentansprüche**

**1.** Fotoempfindliche Zusammensetzung, umfassend

(i) einen Infrarotabsorber,
(ii) eine Boratverbindung,
(iii) eine polymerisierbare Verbindung, die zumindest eine ethylenisch ungesättigte Doppelbindung enthält,
(iv) ein Bindemittelpolymer und
(v) eine Verbindung, die ein gewichtsgemitteltes Molekulargewicht von nicht mehr als 3.000 aufweist und zumindest eine Carbonsäuregruppe enthält,

vorausgesetzt, daß die folgenden zwei Zusammensetzungen ausgenommen sind, worin die Boratverbindung (ii) eine Verbindung der folgenden Formel:

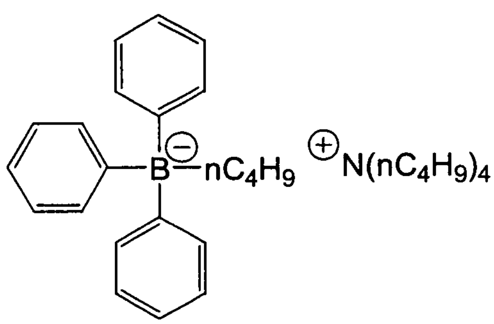

ist und die Verbindung (v) aus den folgenden zwei Formeln ausgewählt ist:

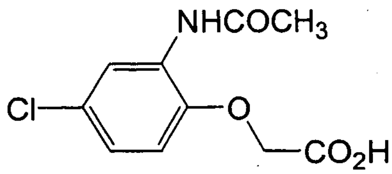

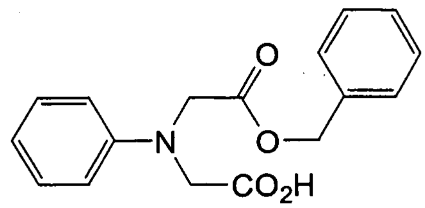

2. Fotoempfindliche Zusammensetzung gemäß Anspruch 1, worin die Verbindung (v) zwei oder mehr Carbonsäuregruppen oder zumindest eine Säuregruppe, die sich von einer Carbonsäuregruppe unterscheidet, enthält.

3. Fotoempfindliche Zusammensetzung gemäß Anspruch 1 oder 2, worin das gewichtsgemittelte Molekulargewicht der Verbindung (v) 60 bis 2.000 beträgt.

4. Fotoempfindliche Zusammensetzung gemäß irgendeinem der Ansprüche 1 bis 3, worin der Gehalt der Verbindung (v) 0,5 bis 30 Gew.% beträgt, bezogen auf den Gesamtfeststoffgehalt.

5. Fotoempfindliche Zusammensetzung gemäß irgendeinem der Ansprüche 1 bis 4, worin die Verbindung (v) aus den Formeln (1) bis (21) ausgewählt ist:

1

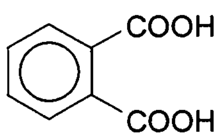

2

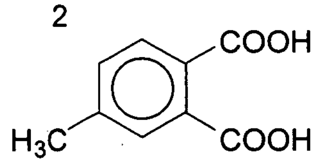

3

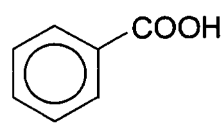

4

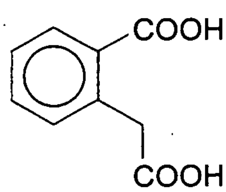

5

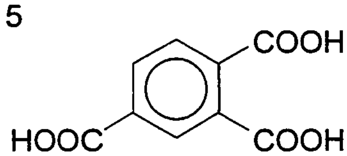

6

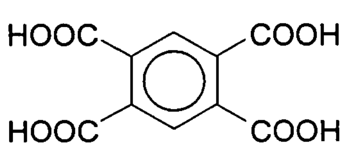

7

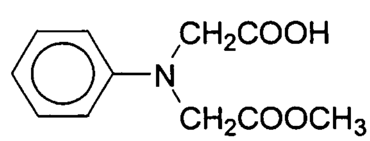

8
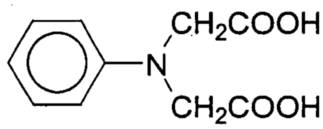

9
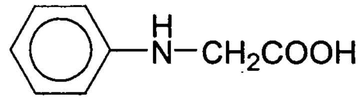

10
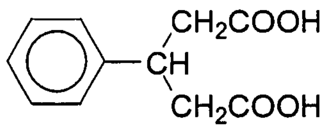

11
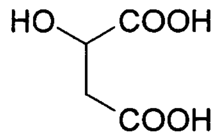

12
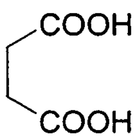

13
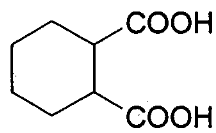

14
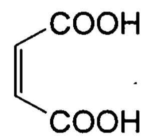

15
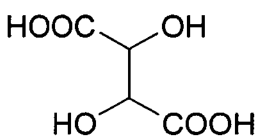

16
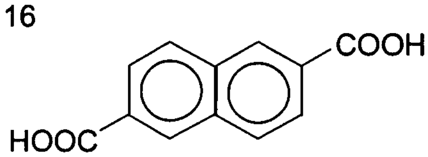

17
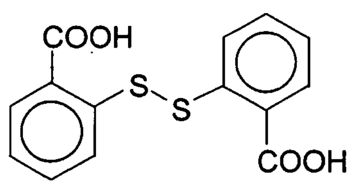

18
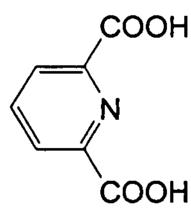

19
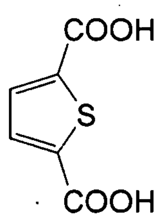

20
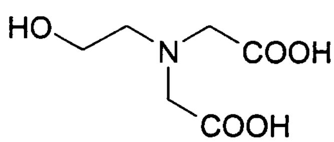

21
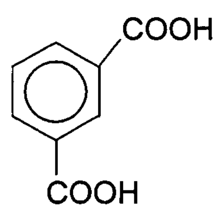

**6.** Fotoempfindliche Zusammensetzung gemäß irgendeinem der Ansprüche 1 bis 5, worin die Boratverbindung eine durch die folgende Formel (I) dargestellte Verbindung ist:

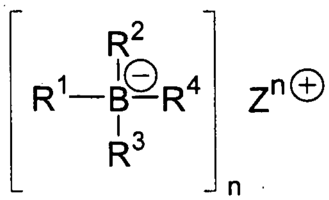

(I)

worin
$R^1$, $R^2$, $R^3$ und $R^4$ jeweils unabhängig voneinander eine organische Gruppe darstellen, vorausgesetzt, daß zumindest eines von $R^1$, $R^2$, $R^3$ und $R^4$ eine Alkylgruppe ist;
$Z^{n+}$ ein Kation mit einer Wertigkeit (Valenz) n ist; und
n eine ganze Zahl von 1 bis 6 ist.

**7.** Fotoempfindliche Zusammensetzung gemäß Anspruch 1, worin die Boratverbindung (ii) zumindest eine Phenylgruppe aufweist, die an deren m-Position mit Fluor substituiert ist.

**8.** Fotoempfindliche Zusammensetzung gemäß Anspruch 1, die ferner ein Oniumsalz umfaßt.

**9.** Lithographie-Druckplattenvorläufer, umfassend in dieser Reihenfolge einen Träger, eine fotoempfindliche Schicht, die die fotoempfindliche Zusammensetzung gemäß irgendeinem der Ansprüche 1 bis 8 umfaßt, und eine Schutzschicht.

**Revendications**

**1.** Composition photosensible contenant

(i) un absorbeur d'infrarouge,
(ii) un composé boraté
(iii) un composé polymérisable contenant au moins une double liaison à insaturation éthylénique
(iv) un polymère liant, et
(v) un composé présentant un poids moléculaire moyen en masse non supérieur à 3000, et contenant au moins un groupement acide carboxylique.

avec la condition que les deux compositions suivantes, où le composé boraté (ii) est un composé de la formule suivante:

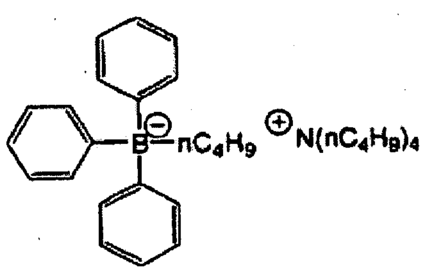

et le composé (v) est choisi parmi les deux formules suivantes

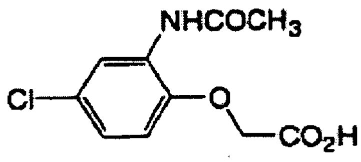

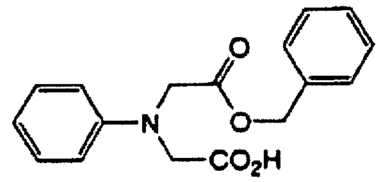

sont exclues.

2. Composition photosensible selon la revendication 1, dans laquelle le composé (v) contient deux groupements acide carboxylique ou plus, ou au moins un groupement acide autre qu'un groupement acide carboxylique.

3. Composition photosensible selon la revendication 1 ou 2, dans laquelle le poids moléculaire moyen en masse du composé (v) est 60-2000.

4. Composition photosensible selon l'une quelconque des revendications 1-3, dans laquelle la teneur du composé (v) est de 0,5-30 % massique, sur base de la teneur en solide totale.

5. Composition photosensible selon l'une quelconque des revendications 1-4, dans laquelle le composé (v) est choisi par les formules (1)-(21):

1

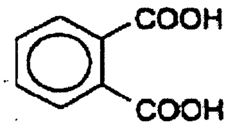

2

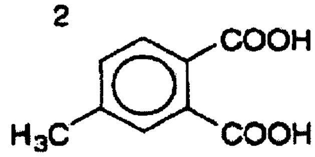

3

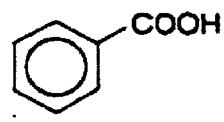

4

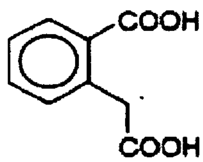

5

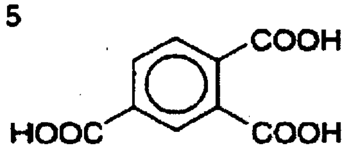

6

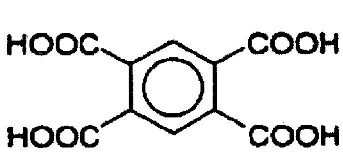

7

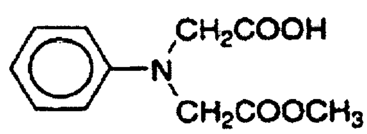

8

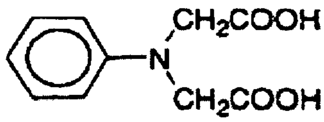

9

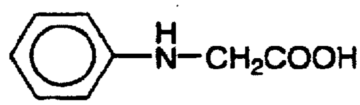

10

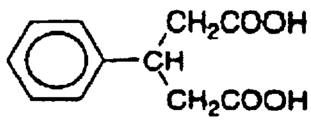

11

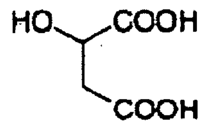

12

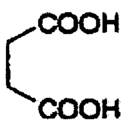

13

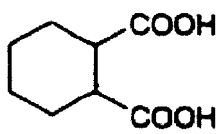

14

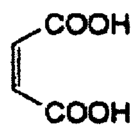

15

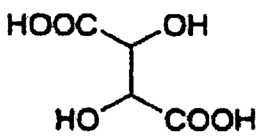

16

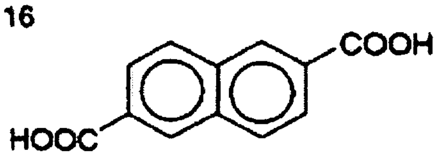

17

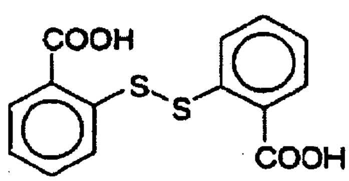

18

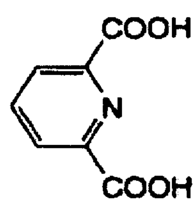

19

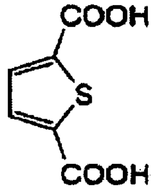

20

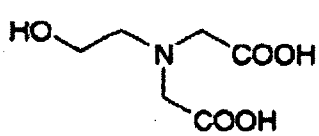

21

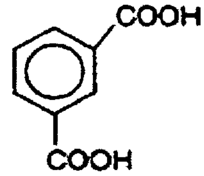

6. Composition photosensible selon l'une quelconque des revendications 1-5, dans laquelle le composé boraté est un composé représenté par la formule (I) suivante:

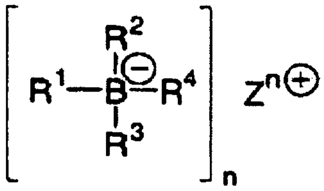

(I)

dans laquelle
$R^1$, $R^2$, $R^3$ et $R^4$ représentent chacun indépendamment un groupement organique, avec la condition que l'un au moins parmi $R^1$, $R^2$, $R^3$ et $R^4$ est un groupement alkyle;
$Z^{n+}$ est un cation de valence n; et
n est un entier de 1 à 6.

7. Composition photosensible selon la revendication 1, dans laquelle le composé boraté (ii) contient au moins un groupement phényle substitué par le fluor en position m.

8. Composition photosensible selon la revendication 1, contenant de plus un sel d'onium.

9. Précurseur de plaque d'impression lithographique comprenant, dans cet ordre, un support, une couche photosensible contenant la composition photosensible selon l'une quelconque des revendications 1-8, et une couche de protection.

FIG. 1

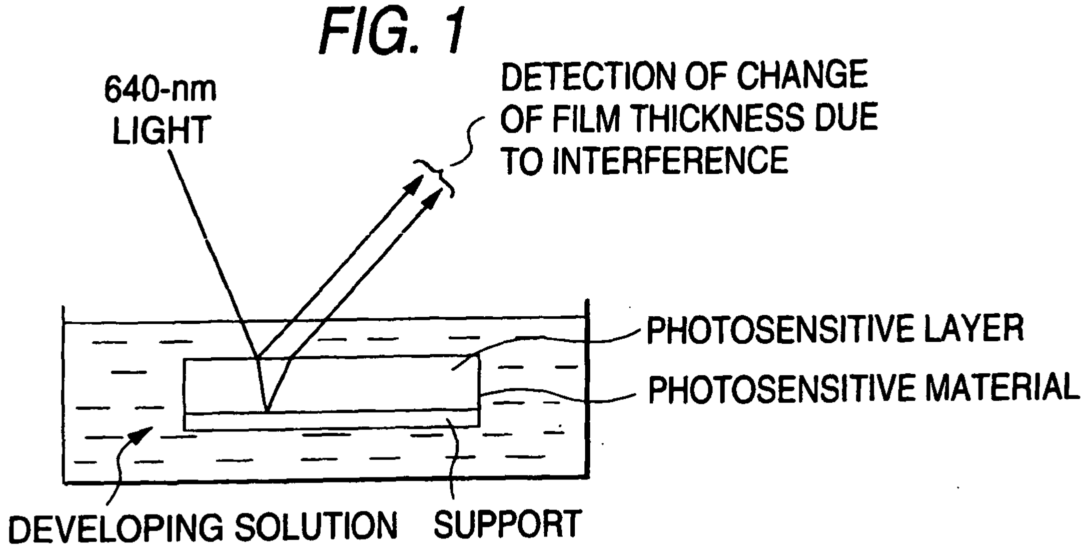
640-nm
LIGHT
DETECTION OF CHANGE
OF FILM THICKNESS DUE
TO INTERFERENCE
PHOTOSENSITIVE LAYER
PHOTOSENSITIVE MATERIAL
DEVELOPING SOLUTION
SUPPORT

FIG. 2

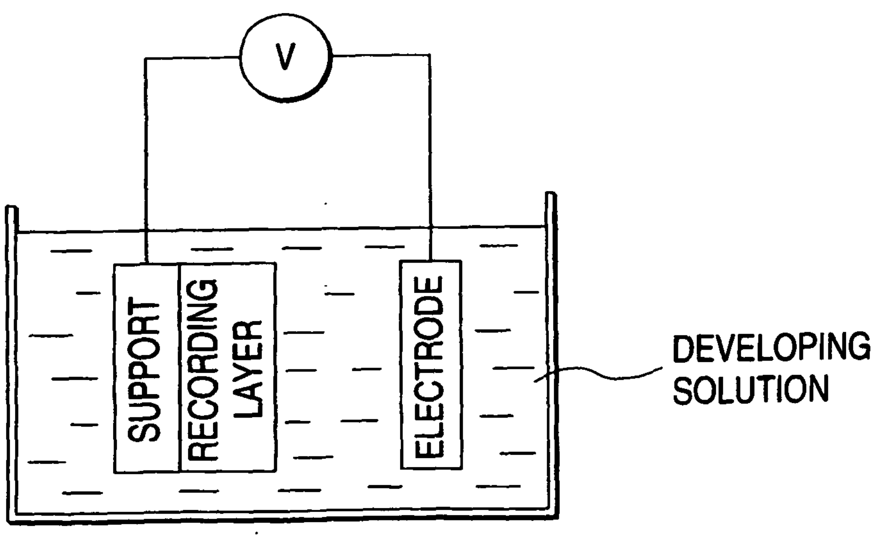
V
SUPPORT
RECORDING
LAYER
ELECTRODE
DEVELOPING
SOLUTION

FIG. 3

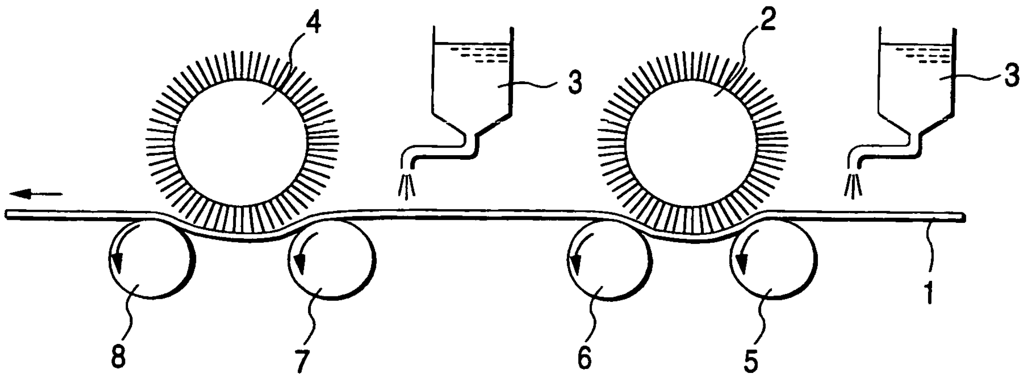


FIG. 4

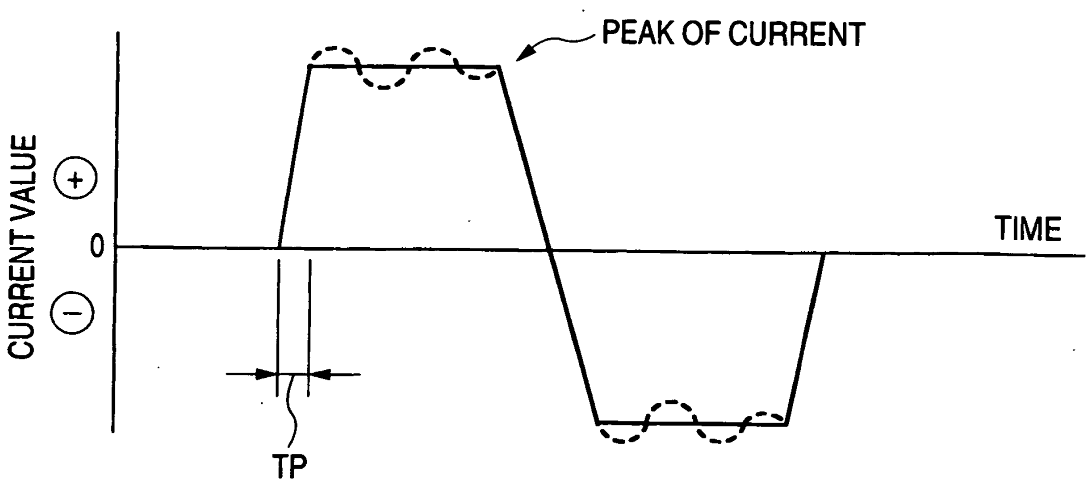

FIG. 5

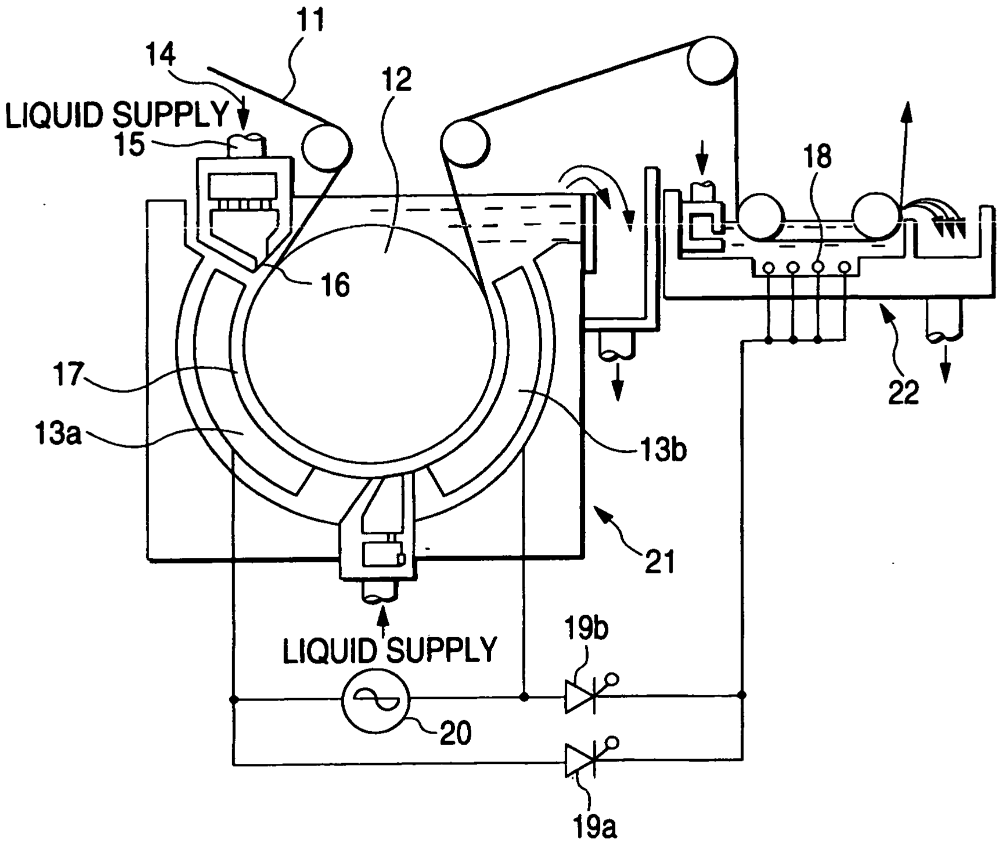
11
14
12
LIQUID SUPPLY
15
18
16
17
13a
13b
22
21
LIQUID SUPPLY
19b
20
19a

FIG. 6

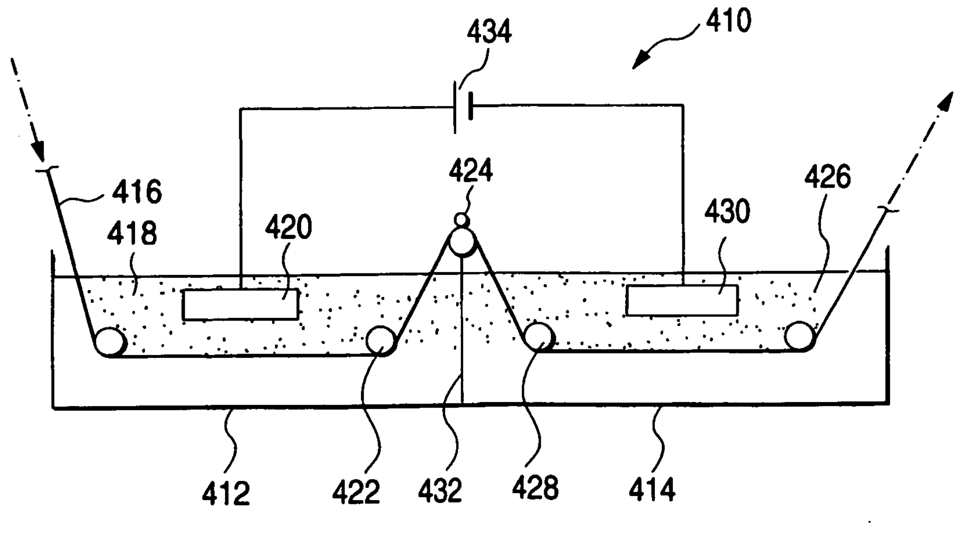
434
410
424
416
418
420
430
426
412
422
432
428
414

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0048836 A
- JP 2002090989 A
- JP 2002023361 A
- EP 1449651 A
- EP 1431032 A
- EP 1391784 A
- US 5496903 A
- JP 2002116539 A
- JP 62143044 A
- JP 62150242 A
- JP 5005988 A
- JP 5197069 A
- JP 2001133969 A
- JP 2002148790 A
- JP 2002350207 A
- JP 2002006482 A
- JP 58125246 A
- JP 59084356 A
- JP 59202829 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60073744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2001006326 A
- JP 2002278057 A
- JP 46027926 B
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 59044615 A
- JP 54034327 B
- JP 58012577 B
- JP 54025957 B
- JP 54092723 B
- JP 59053836 A
- JP 59071048 A
- JP 7012004 B
- JP 7120041 B
- JP 7120042 B
- JP 8012424 B
- JP 63287944 A
- JP 63287947 A
- JP 1271714 A
- JP 13312062 A
- JP 48018327 B
- JP 56028893 A
- JP 53012739 A
- JP 48028123 B
- US 3658662 A
- JP 46027481 B
- JP 52058602 A

- JP 52030503 A
- JP 50007481 B
- JP 54072104 A
- JP 59101651 A
- JP 60149491 A
- JP 60232998 A
- JP 3056177 A
- JP 4282637 A
- JP 5016558 A
- JP 5246171 A
- JP 7159983 A
- JP 7314937 A
- JP 8202025 A
- JP 8320551 A
- JP 9034104 A
- JP 9236911 A
- JP 9269593 A
- JP 10069092 A
- JP 10115931 A
- JP 10161317 A
- JP 10260536 A
- JP 10282682 A
- JP 11084674 A
- JP 11038635 A
- JP 11038629 A
- JP 10282645 A
- JP 10301262 A
- JP 11024277 A
- JP 11109641 A
- JP 10319600 A
- JP 11327152 A
- JP 2000010292 A
- JP 2000235254 A
- JP 2000352824 A
- JP 2001209170 A
- US 3458311 A
- JP 55049729 B
- JP 55049729 A
- US 4882246 A
- JP 50026601 A
- JP 58054341 A
- JP 56039464 B
- JP 56042860 B
- JP 57007427 B
- JP 54008002 A
- JP 55115045 A
- JP 59058431 A

**Non-patent literature cited in the description**

- Dye Handbook. The Society of Synthetic Organic Chemistry, 1970
- Saishin Ganryo Binran. Nippon Ganryo Pigment Kyokai, 1977
- Saishin Ganryo Ohyo Gijutsu. CMC Publishing Co., Ltd, 1986
- Insatsu Inki Gijutsu. CMC Publishing Co., Ltd, 1984
- Kinzoku Sekken No Seishitsu To Ohyo. Saiwai Shobo
- *Journal of The Adhesion Society of Japan,* 1984, vol. 20 (7), 300-308